(19) Europäisches Patentamt
European Patent Office
Office européen des brevets

(11) **EP 2 585 844 B1**

(12) **EUROPÄISCHE PATENTSCHRIFT**

(45) Veröffentlichungstag und Bekanntmachung des Hinweises auf die Patenterteilung:
**24.12.2014 Patentblatt 2014/52**

(21) Anmeldenummer: **11735820.0**

(22) Anmeldetag: **20.06.2011**

(51) Int Cl.:
**G01R 33/58** (2006.01)    **G01R 33/46** (2006.01)

(86) Internationale Anmeldenummer:
**PCT/EP2011/060262**

(87) Internationale Veröffentlichungsnummer:
**WO 2011/161068 (29.12.2011 Gazette 2011/52)**

(54) **KOOPERATIVE PULSE**

COOPERATIVE PULSES

IMPULSIONS COOPÉRANTES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.06.2010 DE 102010024699**

(43) Veröffentlichungstag der Anmeldung:
**01.05.2013 Patentblatt 2013/18**

(73) Patentinhaber: **Technische Universität München 80333 München (DE)**

(72) Erfinder:
• **GLASER, Steffen J.**
**85748 Garching (DE)**
• **BRAUN, Michael**
**81541 München (DE)**

(74) Vertreter: **Kohler Schmid Möbus Patentanwälte Ruppmannstraße 27 70565 Stuttgart (DE)**

(56) Entgegenhaltungen:
**JP-A- 4 174 380**

• **SKINNER T E ET AL: "Application of optimal control theory to the design of broadband excitation pulses for high-resolution NMR", JOURNAL OF MAGNETIC RESONANCE, ACADEMIC PRESS, ORLANDO, FL, US, Bd. 163, Nr. 1, 1. Juli 2003 (2003-07-01), Seiten 8-15, XP004435379, ISSN: 1090-7807, DOI: 10.1016/S1090-7807(03)00153-8 in der Anmeldung erwähnt**
• **BRAUN M ET AL: "Cooperative pulses", JOURNAL OF MAGNETIC RESONANCE ACADEMIC PRESS INC. USA, Bd. 207, Nr. 1, 25. August 2010 (2010-08-25), Seiten 114-123, XP000002659423, ISSN: 1090-7807**
• **TOSNER Z ET AL: "Optimal control in NMR spectroscopy: Numerical implementation in SIMPSON", JOURNAL OF MAGNETIC RESONANCE, ACADEMIC PRESS, ORLANDO, FL, US, Bd. 197, Nr. 2, 8. Dezember 2008 (2008-12-08), Seiten 120-134, XP026087302, ISSN: 1090-7807, DOI: 10.1016/J.JMR.2008.11.020 [gefunden am 2008-12-08] in der Anmeldung erwähnt**
• **Levitt M.H: "Composite Pulses" In: Grant D.M.: "Encyclopedia of Nuclear Magnetic Resonance", 1996, John Wiley & Sons, Chichester, XP000002659424, Bd. 2, Seiten 1396-1411, in der Anmeldung erwähnt chapter 5.4**

**EP 2 585 844 B1**

## Beschreibung

Die vorliegende Erfindung betrifft ein Verfahren zur simultanen Optimierung einer beliebigen Zahl von elektromagnetischen Pulsen, die auf kooperative Weise wirken beziehungsweise ihre Fehler gegenseitig ausgleichen. D. h. die Erfindung betrifft allgemein Pulse, die im Zusammenspiel bessere Eigenschaften haben können als einzelne Pulse. In Experimenten mit mehreren Scans können durch COOP-Pulse unerwünschte Signalbeiträge unterdrückt werden, was das Konzept des Phasenzykeln ergänzt und verallgemeinert. COOP-Pulse können mithilfe einer erweiterten Version des auf Optimal-Control-Theorie basierenden Gradient Ascent Pulse Engineering (GRAPE) Algorithmus' effizient optimiert werden. Der Vorteil des COOP-Puls-Verfahrens wird in Theorie und Experiment für breitbandige und bandselektive Anregungs- und Sättigungspulse gezeigt.

Es ist allgemein bekannt, dass Radiofrequenzpulse die Systemzustände von Spinsystemen beeinflussen können. Dabei bezeichnet der Begriff "Systemzustände" im Sinne der vorliegenden Erfindung sämtliche physikalischen Zustände, die eine Vielzahl von gekoppelten oder ungekoppelten Spins einnehmen kann. Dabei kann sich ein Systemzustand aus einem oder mehreren Einzelbeiträgen zusammensetzen. So beschreiben Levitt (Prog. Nucl. Magn. Reson. Spectrosc. 18 (1986) 61-122 und in "Encyclopedia of Nuclear Magnetic Resonance", Eds. D. M. Grant und R. K. Harris (Wiley, 1996) und Warren und Silver ( Adv. Magn. Reson. 12 (1988) 247-384), dass zusätzlich zu einfachen rechteckigen Radiofrequenz(RF)pulsen mit konstanten Amplituden und Phasen, zusammengesetzte und geformte Pulse leistungsfähige Werkzeuge für die Manipulation von Spins in der NMR-Spektroskopie und im Imaging darstellen. In der Praxis werden sowohl zusammengesetzte als auch geformte Pulse als eine Sequenz von Rechteckpulsen (mit unterschiedlichen Amplituden und Phasen) implementiert. Im Folgenden werden wir den allgemeinen Begriff "Puls" sowohl für zusammengesetzte als auch für geformte Pulse verwenden. In der Gegenwart experimenteller Einschränkungen und Fehler wie maximale RF-Amplituden und RF-Inhomogenität ist die erreichbare Pulsqualität eines Pulses durch die Pulsdauer beschränkt.

Abhängig von der Aufgabe eines Pulses in einem Experiment gibt es erwünschte und unerwünschte Einzelbeiträge der Systemzustände: So sind erwünschte Einzelbeiträge der Systemzustände im Sinne der vorliegenden Erfindung die Einzelbeiträge der Systemzustände, die dem Systemzustand, den die einem bestimmten Experiment zugrundeliegende Theorie erfordert, entspricht. Unerwünschte Einzelbeiträge der Systemzustände hingegen sind die Einzelbeiträge der Systemzustände, die von dem Systemzustand, den die einem bestimmten Experiment zugrundeliegende Theorie erfordert, abweichen. Unerwünschte Einzelbeiträge zum Systemzustand umfassen

- Phasenfehler
- Signale von Kernen mit bestimmter Resonanzfrequenz (Bandselektive Pulse, Lösemittelunterdrückung)
- Entkopplungsseitenbanden
- von einem gewünschten Profil abweichende Signal-Amplituden, wobei beispielsweise ein gewünschtes Profil abhängig sein kann von Frequenz-Offset und/oder von der $B_1$-Feldstärke und/oder von Kopplungskonstanten (umfassend skalare Kopplung, dipolare Kopplung, quadrupolare Kopplung) und/oder von Relaxationsraten (umfassend Autorelaxation, Kreuzrelaxation, autokorrelierte Relaxation, kreuzkorrelierte Relaxation) und/oder von Diffusionsraten und/oder von chemischen Austauschraten und/oder von chemischen Reaktionaraten und/oder von räumlichen Koordinaten, wobei ein gewünschtes Profil von beliebiger Form sein kann, beispielsweise konstante Signal-Amplitude, linear abhängige Signal-Amplitude, quadratisch abhängige Signal-Amplitude, polynomisch abhängige Signal-Amplitude, exponentiell oder logarithmisch abhängige Signal-Amplitude, von einer Zufallsfunktion abhängige Signal-Amplitude.
- Signale von Kernen mit unerwünschten Multiplizitäten
- Signale unerwünschter Kohärenzordnungen (Null-, Einzel-, Doppel, Tripel-Quantenkohärenzen und höhere Kohärenzordnungen)
- Signale aus unerwünschten Kohärenztransferwegen
- Signale mit bestimmten $T_1$- und/oder $T_2$-Relaxationszeiten oder
- Signale von Kernen, die direkte Kopplung zu einem bestimmten Isoptop aufweisen (Isotopenfilter).

Beispielhaft ist bei einem Inversionspuls ausgehend von Gleichgewichts-$z$-Magnetisierung- $z$-Magnetisierung ein erwünschter Systemzustand, alle verbleibenden Komponenten, beispielsweise Komponenten entlang der $+z$-Achse sowie alle transversalen Komponenten sind in diesem Beispiel unerwünschte Systemzustände.

Kobzar et al. (J. Magn. Reson. 170 (2004) 236-243 und J. Magn. Reson. 194, 58-66 (2008)) und Neves et al. (J. Magn. Reson. 181 (2006) 126-134) beschreiben die Ermittlung der physikalischen Grenzen der Pulsqualität bei der Verwendung von Methoden der Optimal-Control-Theorie, wie sie Bryson und Ho (Applied Optimal Control, Hemisphere, Washington, D.C. (1975)) beschreiben. Es gibt zum Beispiel für eine gegebene maximale RF-Amplitude und eine gewünschte Bandbreite sowie Robustheit bezüglich RF-Inhomogenität eine minimale Pulsdauer $T^*$, die nötig ist, um einen gewünschten Qualitätsfaktor oder Leistungsindex zu erreichen. Es ist nicht möglich, dass ein *einzelner* Puls seine Fehler um das gewünschte Maß kompensiert, wenn die Pulsdauer kürzer ist als *T\**. Hier zeigen wir, dass die Pulsdauern weiter reduziert werden können, wenn man den Pulsen erlaubt, ihre Fehler *gegenseitig* auszugleichen. Im Folgenden werden wir diese Klasse *koop*erativ wirkender Pulse als COOP-Pulse bezeichnen. Beispielsweise sind in Experimenten mit mehreren Scans Fehler einzelner Scans irrelevant, falls sich diese Fehler im gesamten akkumulierten Signal auslöschen. Keeler (Understanding NMR Spectroscopy, Wiley, Chichester, 2005), Bodenhausen et al. (J. Magn. Reson. 58 (1984) 370-388), Bain (J. Magn. Reson. 56 (1984) 418-427) Levitt et al. (J. Magn. Reson. 155 (2002) 300-306) beschreiben das in vielen Experimenten mit mehreren Scans zur Unterdrückung von Artefakten oder unerwünschten Signalen verwendete Phasenzykeln, wobei bei jedem Scan eine Sequenz identischer (geformter) Pulse wiederholt wird, abgesehen von einer systematischen Variation der Puls- (und Empfänger-) Phasen. Wir zeigen hier, dass es möglich ist, die Qualität von Pulssequenzen zu verbessern, indem nicht nur die gesamte Phase eines gegebenen Pulses in aufeinanderfolgenden Scans verändert wird, sondern indem durch eine Gruppe von sorgfältig entwickelten COOP-Pulsen gezykelt wird, die im Allgemeinen nicht identisch sind. Khaneja et al. (J. Magn. Reson. 172 (2005) 296-305) und To)š1ner et al. (J. Magn. Reson. 197 (2009) 120-134) beschreiben den auf Optimal-Control-Theorie basierenden Gradient Ascent Pulse Engineering (GRAPE) Algorithmus', der in einer angepassten Version zur Optimierung von Gruppen stark kompensierender COOP-Pulsen verwendet werden kann.

Die Optimierung eines einzelnen (geformten oder zusammengesetzten) Pulses erfolgt standardmäßig durch den auf Optimal-Control-Theorie basierenden Gradienten-Anstiegs-Algorithmus GR.APE ("gradient ascent pulse engineering").

Es sei angenommen, wir suchen für einen anfänglichen Magnetisierungsvektor *M*(0) einen Puls der Dauer T, der einen definierten Güteindex oder Qualitätsfaktor Φ optimiert, wobei wir hier der Einfachheit halber (aber ohne Beschränkung der Allgemeinheit) annehmen, dass Φ nur vom Endmagnetisierungsvektor *M*(*T*) abhängt. Beispielsweise beginnen wir bei einem Anregungspuls mit *z*-Magnetisierung, d. h. *M*(0) = (0, 0, 1)$^t$. Skinner et al. beschreiben (J. Magn. Reson. 163 (2003) 8-15), wie ein einfacher Qualitätsfaktor als die *x*-Komponente der Endmagnetisierung definiert werden kann. Ein gegebener Puls wird vollständig durch die zeitabhängigen *x*- und *y*-Komponenten $v_x(t)$ = -γ$B_{rf,x}(t)$/2π und $v_y(t)$ = -γ$B_{rf,y}(t)$/2π (oder alternativ durch die totale RF-Amplitude $\nu_{rf}(t) = \sqrt{\nu_x^2(t) + \nu_y^2(t)}$ und RF-Phase $\varphi(t)$ = tan$^{-1}${$v_y(t)$)/$v_x(t)$}) charakterisiert.

Der Puls kann dann verbessert werden, falls bekannt ist, wie sich der Qualitätsfaktor Φ verhält, wenn die Kontrollen $v_x(t)$ und $v_y(t)$ variiert werden, d. h. wenn wir die Gradienten δΦ/δ$v_x(t)$ und δΦ/δ$v_y(t)$ kennen. Diese Gradienten können mittels finiter Differenzen approximiert werden.

Bryson et al. (Applied Optimal Control, Hemisphere, Washington, D.C. (1975)), Khanejaet al. (J. Magn. Reson. 172 (2005) 296-305), To)š1ner (J. Magn. Reson. 197 (2009) 120-134), Conolly et al, (IEEE Trans. Med. Imag. MI-5 (1986) 106115) und Skinner et al. (J. Magn. Reson. 163 (2003) 8-1) beschreiben, wie dieselben hochdimensionalen Gradienten δΦ/δ$v_x(t)$ und δΦ/δ$v_y(t)$ basierend auf Prinzipien der Optimal-Control-Theorie effizient in erster Ordnung berechnet werden können. Dieses Verfahren erfordert nur die Berechnung der Trajektorie des Magnetisierungsvektors *M*(*t*) und des sogenannten Costate-Vektors λ(*t*) für 0 ≤ *t* ≤ *T*. Skinner et al. (J. Magn. Reson. 163 (2003) 8-15; J. Magn. Reson. 167 (2004) 68-74; J. Magn. Reson. 172 (2005) 17-23) beschreiben, dass die gewünschten Gradienten gut durch die x- und *y*-Komponente des Kreuzproduktes *M*(*t*) × λ(*t*) angenähert werden:

$$\frac{\delta\Phi}{\delta\nu_x(t)} = M_y(t)\lambda_z(t) - M_z(t)\lambda_y(t), \qquad (1)$$

$$\frac{\delta\Phi}{\delta\nu_y(t)} = M_z(t)\lambda_x(t) - M_x(t)\lambda_z(t). \qquad (2)$$

Für einen Spin mit Offset $v_{off}$ ist der effektive Feldvektor $v_e(t)$ definiert als

$$\boldsymbol{\nu}_e(t) = (\nu_x(t), \nu_y(t), \nu_{off})^t. \qquad (3)$$

Beginnend mit dem Anfangsmagnetisierungsvektor *M*(0) = $M_i$ kann die Trajektorie des Magnetisierungsvektors

$M(t)$ durch Lösen der Bloch-Gleichungen

$$\dot{M}(t) = 2\pi\boldsymbol{\nu}_e(t) \times \boldsymbol{M}(t) \qquad (4)$$

berechnet werden. Rourke (Conc. Magn. Reson. 14 (2002) 112-129) beschreibt Modifikationen der Bloch-Gleichungen zur Berücksichtigung von Relaxation beziehungsweise Radiation Damping.

Hier nehmen wir vereinfachend an, dass Relaxationseffekte vernachlässigt werden können, wobei sie jedoch, sofern notwendig, auf einfache Weise berücksichtigt werden können. Khaneja et al. (J. Magn. Reson. 172 (2005) 296-305) und Gershenzon et al. (J. Magn. Reson. 188 (2007) 330-336) beschreiben wie Relaxationseffekte auf einfache Weise berücksichtigt werden können. Skinner et al. beschreiben (J. Magn. Reson. 163 (2003) 8-15), dass wenn der Qualitäts-faktor $\Phi$ nur vom Magnetisierungsvektor $M(T)$ am Ende des Pulses abhängt, ist der Costate-Vektor $\lambda(T)$ durch $\partial\Phi/\partial M(T)$ gegeben, d. h. die drei Komponenten des Costate-Vektors $\lambda(T) = (\lambda_x(T), \lambda_y(T), \lambda_z(T))^t$ sind

$$\lambda_x(T) = \frac{\partial\Phi}{\partial M_x(T)}, \quad \lambda_y(T) = \frac{\partial\Phi}{\partial M_y(T)}, \quad \lambda_z(T) = \frac{\partial\Phi}{\partial M_z(T)}. \qquad (5)$$

Falls der Qualitätsfaktor beispielsweise einfach die Projektion des Endma gnetisierungsvektors auf einen gewünschten Zielzustand $F$ ist, d. h.

$$\Phi_a = M_x(T)F_x + M_y(T)F_y + M_z(T)F_z, \qquad (6)$$

dann ist der End-Costate-Vektor einfach $\lambda(T) = F$. Falls hingegen der Qualitätsfaktor zum Erreichen eines bestimmten Zielzustandes $F$ definiert ist als

$$\Phi_b = 1 - a_1(M_x(T) - F_x)^2 - a_2(M_y(T) - F_y)^2 - a_3(M_z(T) - F_z)^2, \qquad (7)$$

wie von Skinner et al. (J. Magn. Reson. 172 (2005) 17-23) beschrieben, dann ist der resultierende End-Costate-Vektor gegeben durch $\lambda(T) = -(2a_1(M_x - F_x), 2a_2(M_y - F_y), 2a_3(M_z - F_z))^t$. Hier stehen $a_1$, $a_2$ and $a_3$ für die relativen Gewichtungen, die entsprechend der gewünschten Übereinstimmungsgrade der $x$-, $y$- und $z$-Komponenten des Endmagnetisierungsvektors mit dem Zielzustand vorgegeben werden.

Skinner et al. (J. Magn. Reson. 163 (2003) 8-15; J. Magn. Reson. 167 (2004) 68-74; J. Magn. Reson. 172 (2005) 17-23; ) und Gershenzon et al. (J. Magn. Reson. 188 (2007) 330-336) beschreiben, dass die Bewegungsgleichung für den Costate-Vekor die selbe Form hat wie die Bloch-Gleichungen (vgl. Gl. (4)), d. h.

$$\dot{\boldsymbol{\lambda}}(t) = 2\pi\boldsymbol{\nu}_e(t) \times \boldsymbol{\lambda}(t) \qquad (8)$$

und durch Propagation von $\lambda(T)$ rückwärts in der Zeit erhalten wir $\lambda(t)$ für $0 < t < T$.

Khaneja et al. (J. Magn. Reson. 172 (2005) 296-305) und Skinner et al. (J. Magn. Reson. 163 (2003) 8-15) beschreiben, wie Robustheit bezüglich Offset und RF-Inhomogenität durch Berechnung des Mittelwerts der Gradienten über alle berücksichtigten Offsets $v_{off}$ und RF-Skalierungsfaktoren s erreicht werden kann. Unter Mittelung im Sinne der vorliegenden Erfindung versteht man die Berechnung des Mittelwerts von individuellen Systemzuständen, wobei die Systemzustände mit unterschiedlichen Gewichtungsfaktoren, die sowohl ein positives als auch ein negatives Vorzeichen aufweisen können, in die Berechnung des Mittelwerts eingehen können und der Mittelwert sich erfindungsgemäß durch die folgenden Verfahren umfassend arithmetische, geometrische, harmonische, quadratische oder kubische Mittelung berechnen lässt:

$$\text{arithmetischer Mittelwert} : \overline{x}_{arithm} = \frac{1}{N} \sum_{j=1}^{N} x_j,$$

$$\text{geometrischer Mittelwert} : \overline{x}_{geometr} = \sqrt[N]{\prod_{j=1}^{N} x_j},$$

$$\text{harmonischer Mittelwert} : \overline{x}_{harmon} = \frac{N}{\sum_{j=1}^{N} \left( x_j^{-1} \right)},$$

$$\text{quadratischer Mittelwert} : \overline{x}_{quadr} = \sqrt[2]{\frac{1}{N} \sum_{j=1}^{N} (x_j^2)}$$

$$\text{kubischer Mittelwert} : \overline{x}_{kubisch} = \sqrt[3]{\frac{1}{N} \sum_{j=1}^{N} (x_j^3)},$$

wobei $x_j$ mit $j \in \{1, 2,..., N\}$ den Elementen entspricht, über die gemittelt wird.

Beginnend von einem Anfangspuls mit den RF-Amplituden $v_x(t)$ und $v_y(t)$. kann die Pulsqualität durch Folgen dieses gemittelten Gradienten optimiert werden. Im einfachsten Verfahren kann die Gradienteninformation in Algorithmen, die das Verfahren des steilsten Anstiegs verwenden, eingesetzt werden, aber bei Verwendung von konjugiertc-Gradienten- oder quasi-Newton-Methoden, die ebenso auf den Gradienten $\delta\Phi/\delta v_x(t)$ and $\delta\Phi/\delta v_y(t)$ beruhen, wird oft schnellere Konvergenz beobachtet.

Die vorangegangen beschriebene Methode ist auf die Optimierung von jeweils einem einzelnen Puls beschränkt.

Aufgabe der vorliegenden Erfindung ist ein Optimierungsverfahren bereitzustellen, um simultan eine Gruppe von Pulsen optimieren zu können, so dass diese Pulse auf kooperative Weise zusammen wirken.

Detaillierte Beschreibung der Erfindung

Erfindungsgemäß wird diese Aufgabe durch ein Verfahren zur simultanen Optimierung einer Gruppe von N elektromagnetischen Pulsen $P^{(j)}$, mit $N > 1$, wobei die Pulse zur Beeinflussung von Systemzuständen eines Spinsystems dienen, gelöst, wobei ein auf Optimal Control basierender Algorithmus verwendet wird mit folgenden Schritten:

a. Auswahl von N elektromagnetischen Anfangspulsen $P^{(j)}$ mit Dauer $T^{(j)}$, mit Kontrollen $\nu_x^{(j)}(t)$ und $\nu_y^{(j)}(t)$ und $j \in \{1; 2; ...; N\}$,

b. Berechnung von N Trajektorien der Systemzustände des Spinsystems unter Einwirkung der Pulse $P^{(j)}$ durch Verwenden von quantenmechanischen Bewegungsgleichungen, wobei jeweils ein gegebener Anfangszustand angenommen wird,

c. Definition eines Qualitätsfaktors $\Phi$ der zumindest von den Systemendzuständen zum Zeitpunkt $T^{(j)}$ abhängt und berücksichtigt, dass unerwünschte Einzelbeiträge der Systemzustände eliminiert und erwünschte Einzelbeiträge der Systemzustände erhalten werden sollen,

d. Berechnung von Costates $\lambda^{(j)}(T^{(j)})$,

e. Berechnung von N Trajektorien der Costates $\lambda^{(j)}(t)$ für $0 \leq t \leq T^{(j)}$,

f. Berechnung der Gradienten des Qualitätsfaktors $\Phi$, bezüglich der Kontrollen $\nu_x^{(j)}(t)$ und $\nu_y^{(j)}(t)$ für beliebig viele Zeitpunkte $t$,

g. Addition der mit einer Schrittweite skalierten Gradienten zu den Kontrollen $\nu_x^{(j)}(t)$ und $\nu_y^{(j)}(t)$, wodurch aktualisierte Kontrollen $\nu_x^{(j)}(t)$ und $\nu_y^{(j)}(t)$ erhalten werden,

h. Wiederholung der Schritte b - g unter Verwendung der aktualisierten Kontrollen $\nu_x^{(j)}(t)$ und $\nu_y^{(j)}(t)$ bis ein definiertes Abbruchkriterium erfüllt ist. Vorzugsweise werden in Schritt f die Gradienten des Qualitätsfaktors $\Phi$ zu jedem Zeitpunkt $t$ berechnet.

Eine besonders einfache Variante ist dadurch gekennzeichnet,
dass die Systemzustände des Spinsystems durch die Magnetisierungsvektoren $M^{(j)}(t)$ beschrieben werden, so dass in Schritt b die Trajektorien der Magnetisienmgsvektoren $M^{(j)}(t)$ durch Verwenden der Bloch-Gleichungen für $0 \leq t \leq T,$ berechnet werden,
der Qualitätsfaktor $\Phi$ von den Endmagnetisierungsvektorcn $M^{(j)}(T^{(j)})$ abhängt, in Schritt e die Berechnung der Trajektorien der Costate-Vektoren $\lambda^{(j)}(t)$ für $0 \leq t \leq T^{(j)}$ unter Verwendung der Bewegungsgleichungen für die Costate-Vektorcn erfolgt gemäß

$$\dot{\boldsymbol{\lambda}}(t) = 2\pi\nu_e(t) \times \boldsymbol{\lambda}(t), \qquad (9)$$

und in Schritt f die Berechnung der Gradienten des Qualitätsfaktors $\Phi$ durch Berechnung der $x$- und $y$-Komponenten des Vektorproduktes $M^{(j)}(t) \times \lambda^{(j)}(t)$ erfolgt:

$$\frac{\delta\Phi}{\delta\nu_x^{(j)}(t)} = M_y^{(j)}(t)\lambda_z^{(j)}(t) - M_z^{(j)}(t)\lambda_y^{(j)}(t), \qquad (10)$$

$$\frac{\delta\Phi}{\delta\nu_y^{(j)}(t)} = M_z^{(j)}(t)\lambda_x^{(j)}(t) - M_x^{(j)}(t)\lambda_z^{(j)}(t). \qquad (11)$$

Eine alternative Variante ist dadurch gekennzeichnet,
dass die Systemzustände mit Hilfe des Dichteoperatorformalismus oder des Produktoperatorformalismus beschrieben oder Modifikationen dieser Formlismen zur Berücksichtigung von Relaxation oder Radiation Damping beschrieben werden.
Die in Schritt f berechnete Gradienteninformation kann in Algorithmen, die das Verfahren des steilsten Anstiegs verwenden, eingesetzt werden.
Alternativ hierzu können die in Schritt f berechneten Gradienten durch Anwendung eines konjugierten-Gradienten-Verfahrens oder eines quasi-Newton-Verfahrens skaliert werden und diese skalierten Gradienten in Schritt g zu den Kontrollen $\nu_x^{(j)}(t)$ und $\nu_y^{(j)}(t)$ addiert werden.
Eine spezielle Variante ist dadurch gekennzeichnet,
dass die Pulse in aufeinander folgenden Scans an einer einzigen Stelle der Pulssequenz zur Anwendung kommen sollen, und
dass der Qualitätsfaktor $\Phi$ vom Mittelwert der Systemendzustände abhängt. Dabei können die Beiträge der Scans zum Mittelwert der Systemendzustände gewichtet werden.
Eine andere spezielle Variante ist dadurch gekennzeichnet,
dass die Pulse in einem einzigen Scan an unterschiedlichen Stellen einer Pulssequenz zur Anwendung kommen sollen, und
dass die Systemendzustände symmetrisch zu einer Achse in der transversalen Ebene sind.
Hierbei ist es vorteilhaft, wenn die Symmetrieachse in der transversalen Ebene eine einheitliche Phase oder eine Phase, die linear vom Offset abhängt, aufweist.
Bei den Pulsen $P^{(j)}$ handelt es sich vorzugsweise um Pulse, die transversale Magnetisierung erzeugen.
Vorzugsweise hängt der Qualitätsfaktor $\Phi$ ausschließlich von den Systemendzuständen ab.

Besonders vorteilhaft ist das erfindungsgemäße Verfahren, wenn die Pulse zur Beeinflussung von Systemzuständen von gekoppelten Spinsystemen dienen. Vorzugsweise handelt es sich bei den Pulsen um hcteronukleare oder homonukleare Entkopplungspulse zur Unterdrückung der heteronuklearen oder homonuklearen Kopplungsevolution.

Bei einer bevorzugten Variante werden die Entkopplungspulse jeweils in $N_{acq}$ Akquisitionspunkte unterteilt, und der Qualitätsfaktor $\Phi$ hängt von den Systemzuständen zu den Zeiten $T_k$ der $N_{acq}$ Akquisitionspunkte aller $N$ Pulse ab.

In aufeinanderfolgenden Scans können unterschiedliche Entkopplungspulse vorgesehen sein.

Das erfindungsgemäße Verfahren wird vorzugsweise im Bereich der NMR-Spektroskopie, MRI, Elektron-Spin-Resonanz-Spektroskopie und in der optischen Spektroskopie verwendet.

Erfingdungsgemäß werden für eine Gruppe von N beliebig gewählten individuellen Pulsen $P^{(j)}$ mit Dauer $T$ (wobei das Verfahren nicht auf Pulse gleicher Dauern $T^{(j)}$ beschränkt ist), mit RF-Amplituden $\nu_x^{(j)}(t)$ und $\nu_y^{(j)}(t)$ und $j \in \{1,2,...,N\}$, wobei ein gegebener Anfangszustand $M^{(1)}(0) = M^{(2)}(0) = \cdots = M^{(N)}(0) = M_i$ (wobei das Verfahren nicht auf identische Anfangszustände $M^{(j)}(0)$ beschränkt ist) angenommen wird, zunächst die entsprechenden $N$ Trajektorien (= zeitlicher Verlauf) $M^{(j)}(t)$ der Magnetisierungsvektoren unter Einwirkung der Pulse $P^{(j)}$ durch Verwenden der Bloch-Gleichungen für $0 \le t \le T$ berechnet werden, wobei in Abhängigkeit der Endmagnetisierungsvektoren $M^{(j)}(T)$ ein Qualitätsfaktor $\Phi$ (dessen Abhängigkeit nicht auf die Endmagnetisierungsvektoren $M^{(j)}(T)$ beschränkt ist) definiert wird, so dass die Costate-Vektoren $\lambda^{(j)}(T)$ gegeben sind durch

$$\lambda_x^{(j)}(T) = \frac{\partial \Phi}{\partial M_x^{(j)}(T)}, \quad \lambda_y^{(j)}(T) = \frac{\partial \Phi}{\partial M_y^{(j)}(T)}, \quad \lambda_z^{(j)}(T) = \frac{\partial \Phi}{\partial M_z^{(j)}(T)}, \quad (12)$$

worauf die $N$ Trajektorien $\lambda^{(j)}(t)$ für $0 \le t \le T$ unter Verwendung der Bewegungsgleichungen für die Costato-Vektoren gemäß Gleichung (8) berechnet werden, worauf die Gradienten des Qualitätsfaktors $\Phi$, so wie es Skinner et al. (J. Magn. Reson. 163 (2003) 8-15) beschrieben haben, bezüglich der Kontrollen $\nu_x^{(j)}(t)$ und $\nu_y^{(j)}(t)$ zu jedem Zeitpunkt $t$ berechnet werden durch Berechnung der $x$- und $y$-Komponenten der Vektoren $M^{(j)}(t) \times \lambda^{(j)}(t)$:

$$\frac{\delta \Phi}{\delta \nu_x^{(j)}(t)} = M_y^{(j)}(t)\lambda_z^{(j)}(t) - M_z^{(j)}(t)\lambda_y^{(j)}(t), \quad (13)$$

$$\frac{\delta \Phi}{\delta \nu_y^{(j)}(t)} = M_z^{(j)}(t)\lambda_x^{(j)}(t) - M_x^{(j)}(t)\lambda_z^{(j)}(t), \quad (14)$$

worauf die Gradienten zu den Kontrollen $\nu_x^{(j)}(t)$ und $\nu_y^{(j)}(t)$ addiert werden, wodurch aktualisierte Kontrollen $\nu_x^{(j)}(t)$ und $\nu_y^{(j)}(t)$ erhalten werden, für die in der nächsten Iteration ebenso entsprechende Trajektorien, Costate-Vektoren und Gradienten berechnet werden, wobei dieses iterative Verfahren so oft wiederholt wird, bis ein beliebig definiertes Abbruchkriterium erfüllt ist. Im Folgenden wird das erfindungsgemäße Vefahren genau beschrieben.

Bevor die Gradienten zu den Kontrollen addiert werden, können die Gradienten im erfindungsgemäßen Verfahren mit einem beliebigen Skalierungsfaktor (=Schrittweite) multipliziert werden. Diese Schrittweiten können konstant und variabel sein. Variable Schrittweiten können auf beliebige Weisen berechnet werden, umfassend konjugierte Gradienten, quasi-Newton-Methoden wie BFGS oder limited-memory BFGS (L-BFGS) so wie es beispielsweise von Fouquieres et al. ("Second Order Gradient Ascent Pulse Engineering", submitted to J. Magn. Reson., preprint: arXiv:1102.4096) gezeigt wurde. Jetzt betrachten wir eine Gruppe von $N$ individuellen Pulsen $P^{(j)}$ mit identischer Dauer $T$ (wobei das Verfahren nicht auf Pulse gleicher Dauer beschränkt ist), mit RF-Amplituden $\nu_x^{(j)}(t)$ und $\nu_y^{(j)}(t)$ und $j \in \{1,2,...,N\}$. Für einen gegebenen Anfangszustand $M^{(1)}(0) = M^{(2)}(0) = \cdots = M^{(N)}(0) = M_i$, können die entsprechenden $N$ Trajektorien $M^{(j)}(t)$ der Magnetisierungsvektoren unter Einwirkung der Pulse $P^{(j)}$ durch Verwenden der Bloch-Gleichungen für $0 \le t \le T$ berechnet werden. Ohne Beschränkung der Allgemeinheit nehmen wir der Einfachheit halber an, dass der

Qualitätsfaktor $\Phi$ nur von den Endmagnetisierungsvektoren $M^{(j)}(T)$ abhängt. Dann sind die Komponenten der Costate-Vektoren $\lambda^{(j)}(T)$ gegeben durch

$$\lambda_x^{(j)}(T) = \frac{\partial \Phi}{\partial M_x^{(j)}(T)}, \quad \lambda_y^{(j)}(T) = \frac{\partial \Phi}{\partial M_y^{(j)}(T)}, \quad \lambda_z^{(j)}(T) = \frac{\partial \Phi}{\partial M_z^{(j)}(T)} \quad (15)$$

und die $N$ Trajcktorien $\lambda^{(j)}(t)$ können für $0 \leq t \leq T$ unter Verwendung der Bewegungsgleichungen für die Costate-Vektoren gemäß Gleichung (8) berechnet werden. Skinner et al. beschreiben (J. Magn. Reson. 163 (2003) 8-15), wie der Gradient des Qualitätsfaktors $\Phi$ bezüglich der Kontrollen $\nu_x^{(j)}(t)$ und $\nu_y^{(j)}(t)$ durch die x- und y-Komponenten der Vektoren $M^{(j)}(t) \times \lambda^{(j)}(t)$ gegeben ist:

$$\frac{\delta \Phi}{\delta \nu_x^{(j)}(t)} = M_y^{(j)}(t)\lambda_z^{(j)}(t) - M_z^{(j)}(t)\lambda_y^{(j)}(t), \quad (16)$$

$$\frac{\delta \Phi}{\delta \nu_y^{(j)}(t)} = M_z^{(j)}(t)\lambda_x^{(j)}(t) - M_x^{(j)}(t)\lambda_z^{(j)}(t). \quad (17)$$

Man betrachte beispielsweise die Optimierung von COOP-Anregungspulsen mit minimalem Gesamtphasenfehler. Bei Anwendung in aufeinanderfolgenden Scans sind die reellen und imaginären Anteile des akkumulierten Signals $S_x + iS_y$ proportional zu den x- und y-Komponenten des gemittelten Magnetisierungsvektors

$$\overline{M}(T) = \frac{1}{N} \sum_{j=1}^{N} M^{(j)}(T). \quad (18)$$

Ziel ist $\overline{M}_x(T)$ zu maximieren und $\overline{M}_y(T)$ zu minimieren, um den Phasenfehler des akkumulierten Signals zu minimieren, wobei $\overline{M}_z(T)$ irrelevant ist. Dieses Ziel kann quantifiziert werden durch

$$\Phi_c = 1 - (1 - \overline{M}_x(T))^2 - a\overline{M}_y(T)^2, \quad (19)$$

was eine Verallgemeinerung des Qualitätsfaktors $\Phi_b$ (vgl. Gl. (7)) darstellt, wobei $M(T)$ durch $\overline{M}(T)$ ersetzt wurde, mit $F = (1, 0, 0)^t$, $a_1 = 1$, $a_2 = a$, and $a_3 = 0$. Hierbei kann die relative Gewichtung, die für die Abweichungen von $\overline{M}_x$ und $\overline{M}_y$ von den Zielwerten $F_x = 1$ and $F_y = 0$ vorgegeben wird, durch den Parameter $a$ eingestellt werden. Gemäß Gleichung (15), sind die Costate-Vektoren gegeben durch

$$\lambda^{(j)}(T) = \frac{2}{N}(1 - \overline{M}_x(T), -a\overline{M}_y(T), 0)^t, \quad (20)$$

was von j unabhängig ist, d. h. alle Costate-Vektoren sind am Ende des Pulses identisch ($\lambda^{(1)}(T) = \lambda^{(2)}(T) = \cdots = \lambda^{(N)}(T)$) und abhängig vom gemittelten Endmagnetisierungsvektor $\overline{M}(T)$. Die Rückwärtspropagation der Costate-Vektoren gemäß der unterschiedlichen Pulse $P^{(j)}$ ergibt hingegen verschiedene Trajektorien $\lambda^{(j)}(t)$ für $0 \leq t \leq T$.

Mit den Trajektorien $M^{(j)}(t)$ und $\lambda^{(j)}(t)$ können die Gradienten (16, 17) effizient berechnet werden, was ein leistungsfähiges Werkzeug für die simultane Optimierung einer Gruppe von sich gegenseitig ausgleichenden COOP-Pulsen darstellt. Im nächsten Abschnitt wird anhand anschaulicher Beispiele das COOP-Verfahren erläutert. Experimente wurden an NMR Spektrometern der Typen AV 250 und AV III 600 der Firma Bruker durchgeführt, wobei eine mit Kupfersulfat(CuSO$_4$) versetzte Probe von $\approx$ 1% H$_2$O in D$_2$O verwendet wurde.

Das erfindungsgemäße Verfahren wird im Folgenden beispielhaft beschrieben. Als erstes Beispiel betrachten wir das Problem, *alle* Komponenten des gemittelten Magnetisierungsvektors komplett zu eliminieren, d. h. $\overline{M}_x = \overline{M}_y = \overline{M}_z = 0$, unter Abwesenheit von $B_0$-Gradienten, $B_1$-Inhomogenität und Relaxationseffekten, beginnend von $z$-Magnetisierung. Offensichtlich kann dies nicht von einem einzelnen Puls bewerkstelligt werden und mindestens zwei Scans sind notwendig um dieses Ziel zu erreichen. Wir haben Gruppen von COOP-Pulsen, die aus zwei oder drei individuellen Pulsen bestehen, unter Verwendung des Qualitätsfaktors

$$\Phi_{elim} = 1 - \overline{M}_x(T)^2 - \overline{M}_y(T)^2 - \overline{M}_z(T)^2 \qquad (21)$$

optimiert.

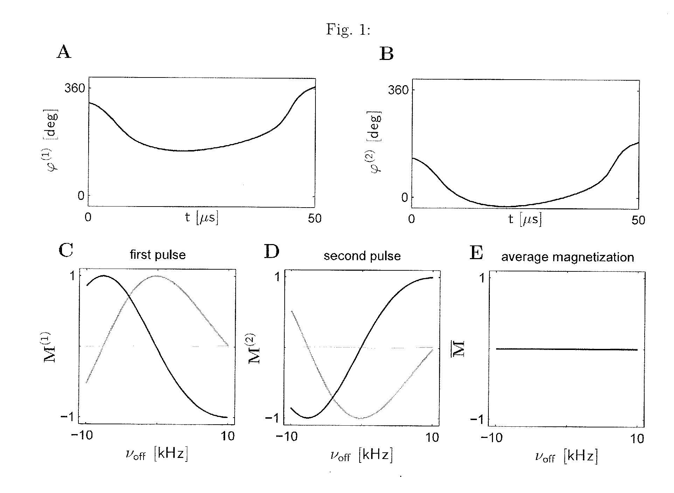

Für den einfachsten Fall eines einzelnen, on-resonanten Spins, findet der erweiterte GRAPE-Algorithmus die intuitive Lösung aus zwei Rechteck-90°-Pulsen mit einer relativen Phasenverschiebung von 180°. Gleichermaßen führt die Optimierung einer Gruppe von drei COOP-Pulsen wie erwartet zu drei Rechteck-90°-Pulsen mit Phasendifferenzen von 120° beziehungsweise 240° (Ergebnisse nicht gezeigt), was zeigt, dass der Algorithmus in der Lage ist, einfache Phasenzyklen wiederzufinden. Falls die Eliminierung der Magnetisierung nicht nur für den Resonanzfall, sondern für einen endlichen Bereich von Offsetfrequenzen und begrenzten RF-Amplituden gewünscht wird, ist die optimale Lösung nicht von vornherein klar. Wir haben für einen Offsetbereich von $\pm$10 kHz und einer maximalen RF-Amplitude von 10 kHz eine Gruppe von COOP-Pulsen optimiert, die aus zwei individuellen Pulsen mit einer Dauer von jeweils 50 $\mu$s besteht. Für jeden individuellen Puls wurde zu Beginn der Optimierung eine unterschiedliche zufällige Pulsform erzeugt, wobei keine Symmetriebeschränkungen festgelegt wurden. Fig. 1 zeigt die optimierten Pulsformen, die Komponenten der Endmagnetisierung nach jedem individuellen Puls und die Komponenten des gemittelten Endmagnetisierungsvektors als eine Funktion des Offsets. Die zwei COOP-Pulse eliminieren wie erwartet effizient den gemittelten Magnetisierungsvektor. Hier besteht die optimale Lösung aus zwei Sättigungspulsen, die abgesehen von einer Gesamtphasendifferenz von 180° identisch sind. Jeder individuelle Sättigungspuls bringt den Magnetisierungsvektor in die transversale Ebene, wodurch die $z$-Komponente in jedem Scan effizient mit hoher Genauigkeit für den gewünschten Offsetbereich eliminiert wird. Die verbleibenden transversalen Magnetisierungskomponenten werden dann dadurch zu Null gemittelt, dass der Sättigungspuls mit einer Phasendifferenz von 180° wiederholt wird. Diese Lösung ist nicht unerwartet, denn ein einzelner Sättigungspuls hätte optimiert werden und phasengezykelt werden können, was zu dem selben Resultat geführt hätte. Es war jedoch zu Beginn in keiner Weise klar, ob dies in der Tat die bestmögliche Strategie ist. Nachdem das COOP-Verfahren nicht auf einen beschränkten Bereich von Lösungen begrenzt ist (z. B. Paare von Sättigungspulsen), ist es ebenso fähig, unerwartete Lösungen zu finden, falls sie existieren, so wie es in den nächsten Beispielen dargelegt werden wird.

Figur 1 zeigt eine Gruppe von zwei COOP-Pulsen zur vollständigen Eliminierung des gemittelten Magnetisierungsvektors $\overline{M}$ für Offsets im Bereich von $\pm$10 kHz für eine konstante RF-Amplitude $v_{rf}$ = 10 kHz und einer Pulsdauer von 50 $\mu$s. A und B zeigen die Phasenmodulationen $\varphi^{(1)}(t)$ und $\varphi^{(2)}(t)$, simulierte Offsetprofile von $M^{(1)}(T)$, $M^{(2)}(T)$ und $\overline{M}(T)$ sind in C, D und E gezeigt. Die $x$-, $y$- und $z$-Komponenten sind in schwarz ($x$), dunkelgrau ($y$) und hellgrau ($z$) gezeigt.

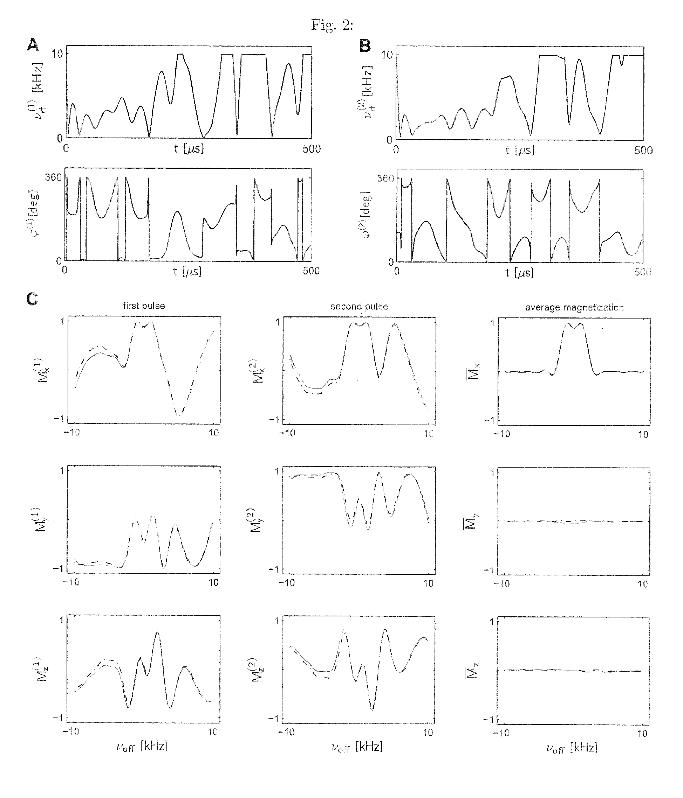

Als zweites Beispiel betrachten wir bandselektive COOP-Pulse die in einem definierten Offsetbereich Magnetisierung anregen und zugleich in anderen Offsetbereichen den gemittelten Magnetisierungsvektor eliminieren. Wir verwenden den Qualitätsfaktor $\Phi_b$ (Gl. (7)) für mehrere, offsetabhängige Zielzustände $F(v_{off})$. Hier betrachten wir das Beispiel, wo $F(v_{off})$ = (1, 0, 0)$^t$ für $|v_{off}| \leq$ 2 kHz (der "Durchlassbereich" ) und $F(v_{off})$ = (0, 0, 0)$^t$ für 2 kHz < $|v_{off}| \leq$ 10 kHz (der "Sperrbereich"). Die Pulsdauer $T$ und die maximale RF-Amplitude $\nu_{rf}^{max}$ wurden auf 500 $\mu$s beziehungsweise 10 kHz gesetzt. Im Gegensatz zum ersten Beispiel ergibt die COOP-Optimierung zwei unterschiedliche Pulse, die sich nicht nur durch eine Gesamtphasendifferenz unterscheiden (Fig. 2). Fig. 2 zeigt auch die simulierten und experimentellen Komponenten der Endmagnetisierung, wie sie durch jeden individuellen Puls erzeugt werden, sowie den gemittelten Magnetisierungsvektor. Obwohl die Antwort der individuellen COOP-Pulse unregelmäßig scheint, ist die Auslöschung der unerwünschten Anteile fast perfekt. Experimentelle (grau )und simulierte (schwarz) Daten stimmen sehr gut überein.

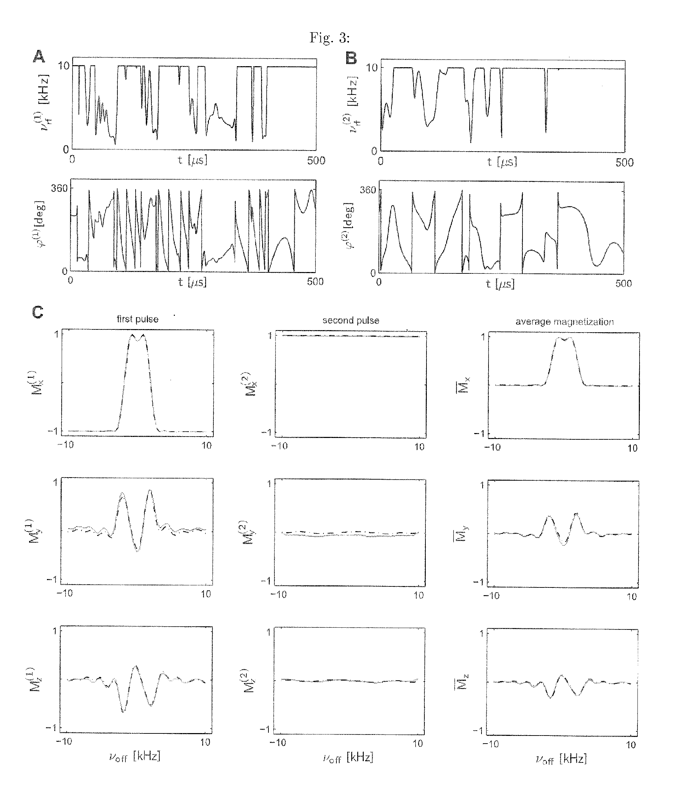

Zum Vergleich zeigt Fig. 3 das Ergebnis einer konventionellen Herangehensweise die auf zwei individuell optimierten Pulsen beruht: ein Breitband-Puls mit dem Zielzustand $F_1(v_{off})$ = (1, 0, 0)$^t$ für $|v_{off}| \leq$ 10 kHz und ein bandselektiver Puls mit $F_2(v_{off})$ = (1, 0, 0)$^t$ für $|v_{off}| \leq$ 2 kHz und $F_2(v_{off})$ = (-1, 0, 0)$^t$ für 2 kHz < $|v_{off}| \leq$ 10 kHz. Diese Pulse erzielen auch das gewünschte Profil für die gemittelte Magnetisierung. Sehr gute Unterdrückung der *x*-Komponente wird durch dieses Verfahren im Sperrbereich erzielt. Jedoch verbleiben große *y*- und *z*-Komponenten des gemittelten Magnetisierungsvektors von mehr als 40% in der Nähe der Übergangsbereiche bei $\pm 2$ kHz (vgl. Fig. 3). Im Gegensatz dazu können mit dem COOP-Verfahren die unerwünschten *y*- und *z*-Komponenten im Durchlassbereich, dem Sperrbereich und im Übergangsbereich fast vollständig unterdrückt werden.

Ähnliche Resultate wurden für bandselektive Inversionspulse und verschiedene Bereiche für die Durchlass- und Sperrbereiche gefunden (Ergebnisse nicht gezeigt). Interessanterweise ergibt das COOP-Verfahren für den Fall von bandselektiven Inversionspulsen (bei gleichzeitiger Eliminierung des gemittelten Magnetisierungsvektors im Sperrbereich), zwei sehr ähnliche Pulse mit einer relativen Phasendifferenz von 180°. In diesem Fall kann das Zielprofil des gemittelten Magnetisierungsvektors durch einen Puls angenähert werden, der die Magnetisierung im Durchlassbereich invertiert und sie im Sperrbereich in die transversale Ebene bringt. Durch wiederholen des Pulses mit einer Phasendifferenz von 180° werden alle transversalen Magnetisierungskomponenten perfekt ausgelöscht. In diesem Fall erzielt das COOP-Verfahren also eine Lösung, die auch aus einem konventionell optimierten Einzelpuls kombiniert mit einem Phasenzyklus konstruiert werden könnte. Dennoch war es zuvor auf keinerlei Weise offenbar, dass dieses Verfahren die optimale Lösung erzielt, die vom naiven Verfahren, nämlich zwei individuell für bandselektive und Breitband-Inversion optimierte Pulse zu kombinieren, offensichtlich sehr verschieden ist.

Figur 2 zeigt eine Gruppe von zwei COOP-Pulsen zur bandselektiven Anregung und Sättigung. Die RF-Amplituden $\nu_{rf}^{(j)}(t)$ und Phasen $\varphi^{(j)}(t)$ für die beiden COOP-Pulse sind in A und B gezeigt. Simulierte (schwarze, gestrichpunktete Graphen) und experimentelle (graue, durchgezogene Graphen) Komponenten von $\boldsymbol{M}^{(1)}(T)$, $\boldsymbol{M}^{(2)}(T)$ and $\overline{M}(T)$ sind in C gezeigt.

Figur 3 zeigt zwei konventionelle Pulse, die unabhängig voneinander für bandselektive bzw. Breitband-Anregung optimiert wurden. Die RF-Amplituden $\nu_{rf}(t)$ und Phasen $\varphi(t)$ für jeden individuellen Puls sind in A und B gezeigt. Simulierte (schwarze, gestrichpunktete Graphen) und experimentelle (graue, durchgezogene Graphen) Komponenten von $\boldsymbol{M}^{(1)}(T)$, $\boldsymbol{M}^{(2)}(T)$ and $\overline{M}(T)$ sind in C gezeigt.

Jetzt wenden wir uns der Frage zu, ob die Dauer von Breitband-Anregungspulsen durch das COOP-Verfahren verkürzt werden kann. Um Phasenfehler im resultierenden Spektrum zu vermeiden, darf ein einzelner Puls zur breitbandigen Anregung von x-Magnetisierung keine signifikanten *y*-Komponenten im gewünschten Offsetbereich erzeugen. Im Gegensatz dazu ist die Erzeugung von relativ großen *y*-Komponenten $|M_y^{(j)}(T)|$ durch die individuellen Elemente einer Gruppe von COOP-Anregungspulsen akzeptabel, vorausgesetzt, dass $|\overline{M}_y(T)|$ klein (und $\overline{M}_x(T)$ groß) ist. Dies verleiht der Optimierimg zusätzliche Freiheitsgrade.

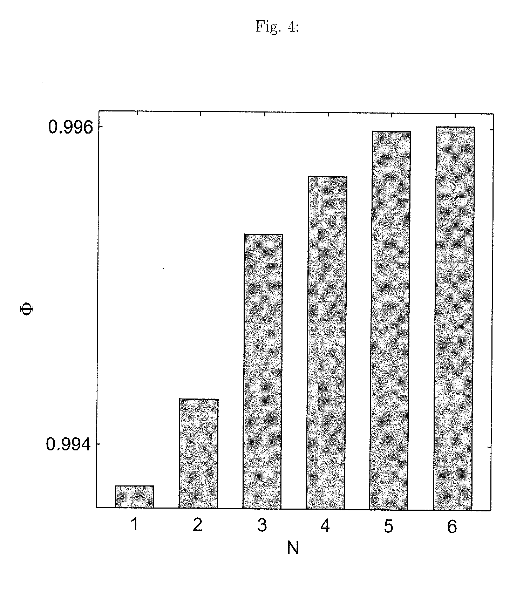

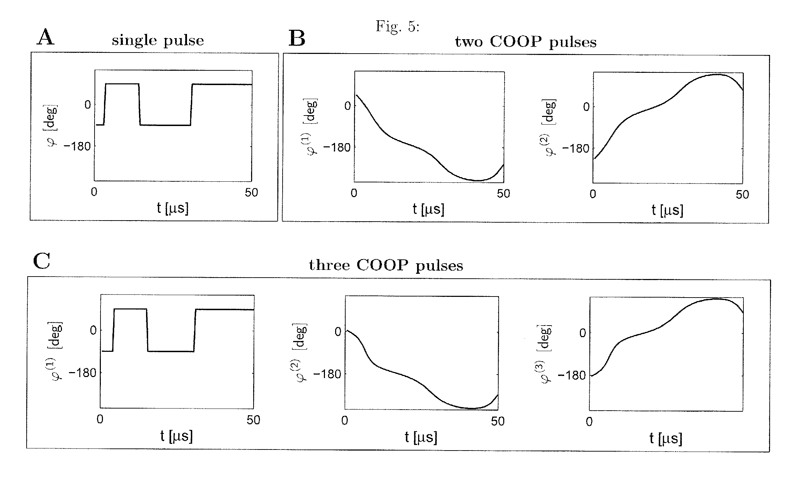

Als konkretes Beispiel betrachten wir die optimale Anregung von x-Magnetisierung mit minimalen Phasenfehlern in einem Offsetbereich von $\pm 20$ kHz mit einer maximalen RF-Amplitude von $\nu_{rf}^{max} = 17.5$ kHz und einer Robustheit bezüglich Abweichungen der RF-Amplitude von $\pm 5\%$. Für dieses Problem konnte die Dauer von effizienten auf Optimal Control basierenden Pulsen von 2 ms (beschrieben von Skinner et al. (J. Magn. Reson. 163 (2003) 8-15)) auf 500 $\mu$s (beschrieben von Skinner et al. (J. Magn. Reson. 167 (2004) 68-74)) reduziert werden, indem der Gradient derart verallgemeinert wurde, dass während der Optimierung RF-Grenzen miteinbezogen werden. Danach konnte die Pulsdauer von Skinner et al. (J. Magn. Reson. 172 (2005) 17-23) sogar noch weiter auf nur 125 $\mu$s reduziert werden, indem ein Qualitätsfaktor identisch mit $\Phi_c$ (Gl. (13)) für $N = 1$ verwendet wurde, der besser an das Problem der Anregung mit minimalen Phasenfehlern angepasst ist als Qualitätsfaktoren, die auf $\Phi_a$ (Gl. (6)) basieren. Für die gleichen Spezifikationen wurden ein Einzelpuls ($N = 1$) und Gruppen von COOP-Pulsen ($N > 1$) unter Verwendung des Qualitätsfaktors $\Phi_c$ (Gl. (19)) optimiert. Der numerisch bestimmte Qualitätsfaktor $\Phi_c$ (Gl. (19) mit $a = 1$) des 125 $\mu$s langen Einzelpulses aus (J. Magn. Reson. 172 (2005) 17-23) beträgt $\Phi_c$ =0.999852. Der Gradient des Qualitätsfaktors für die COOP-Pulsoptimierung kann unter Verwendung der Gleichungen (10-11) effizient in erster Ordnung approximiert werden, wobei $\lambda^{(j)}(T)$ durch Gl. (14) gegeben ist. Beispielsweise kann mit einem erfindungsgemäßen Verfahren ein vergleichbarer Qualitätsfaktor ($\Phi_c = 0.999856$) mit einer Gruppe von drei COOP-Pulsen erreicht werden, mit einer Dauer von nur 100 $\mu$s für jeden individuellen Puls (siehe ergänzende Anhänge). In diesem Fall ist es also möglich, durch die Verwendung des erfindungsgemäßen Verfahrens die Dauer von Anregungspulsen ohne Verlust der Pulsqualität um zusätzliche 20% zu verringern. Die *x*-Komponente des angeregten gemittelten Magnetisierungsvektors beträgt ungefähr 0.99 und der Phasenfehler ist kleiner als 0.4° für den gesamten Offsetbereich von 40 kHz. Um die Leistungsgrenze von sogar noch kürzeren Pulsen zu ermitteln, wurden ebenso Einzel- und COOP-Pulse mit einer Dauer von $T = 50$ $\mu$s, was nur das 3,5-fache der Dauer eines harten 90° Pulses für eine RF-Amplitude von 17,5 kHz ist, optimiert. Fig. 4 zeigt die erzielten Qualitätsfaktoren eines Einzelpulses ($N = 1$) und von COOP-Pulsen mit $N$ von 2 bis 6. Die optimierten Pulse für $N = 1$, 2 und 3 sind in Fig. 5 gezeigt. Alle Pulse besitzen eine konstante Amplitude, womit sie die gesamte erlaubte maximale

RF-Amplitude von $\nu_{rf}^{max} = 17.5\ \text{kHz}$ ausnutzen. Der optimale Einzclpuls ($N$ = 1) ist in Fig. 5 A gezeigt und ist rein phasenalternierend mit den Phasen $\pm\pi/2$. Levitt hat festgestellt (Prog. Nucl. Magn. Reson. Spectrosc. 18 (1986) 61-122), dass diese Klasse von phasenalternierenden Pulsen die folgenden Symmetriebezichungen für die x- und y-Komponenten der angeregten Magnetisierungsvektoern bei den Offsets $\pm v$ impliziert:

$$M_x(\nu) = M_x(-\nu), \qquad (22)$$

$$M_y(\nu) = -M_y(-\nu). \qquad (23)$$

(Zusätzlich ist $M_s(v) = M_z(-v)$, wobei diese Beziehung hier nicht relevant ist, nachdem $\Phi_c$ keine explizite Abhängigkeit von $M_z$ besitzt, vgl. Gl. (13).) Die Symmetriebeziehungen für die x- und y-Komponenten der Endmagnetisierungsvektoren entsprechen der Symmetrie des Problems. Maximales $M_x(v)$ ist sowohl für positive Offsets (zwischen 0 und 20 kHz) und für negative Offsets (zwischen 0 und -20 Khz) gewünscht und, entsprechend Gl. (22), impliziert ein großer Wert für $M_x(v)$ einen gleich großen Wert $M_x(-v)$. Zusätzlich ist $|My|(v) \approx 0$ sowohl für positive als auch für negative Offsets gewünscht und, entsprechend Gl. (23), impliziert ein kleiner Wert für $|M_y(v)|$ ein gleichermaßen kleines $|M_y(-v)|$.

Im Gegensatz zum Fall $N$ = 1 sind die COOP-Pulse für $N$ = 2, die in Fig. 5 B gezeigt sind, nicht phasenalternierend, sondern haben glatte Phasenmodulationen. Diese sind aber nicht unabhängig, sondern sind durch Phaseninversion und einen zusätzliche Phasenverschiebung um $\pi$ ineinander überführbar:

$$\varphi^{(2)}(t) = -\varphi^{(1)}(t) + \pi, \qquad (24)$$

was einer Spiegelung der Phase um $\pi/2$ entspricht. (Für die x- und y-Komponenten der RF-Amplituden entspricht diese Beziehung $\nu_x^{(2)} = -\nu_x^{(1)}$ und $\nu_y^{(2)} = \nu_y^{(1)}$.) Unter Verwendung bekannter Prinzipien der Pussequenzanalyse, wie z. B. von Levitt gezeigt (Prog. Nucl. Magn. Reson. Spectrosc. 18 (1986) 61-122), ist es einfach zu zeigen, dass Gl. (24) die folgenden Symmetriebeziehungen zwischen den transversalen Komponenten der angeregten Magnetisierungvektoren nach dem ersten und zweiten Puls impliziert:

$$M_x^{(2)}(\nu) = M_x^{(1)}(-\nu), \qquad (25)$$

$$M_y^{(2)}(\nu) = -M_y^{(1)}(-\nu). \qquad (26)$$

(Zusätzlich ist $M_z^{(2)}(\nu) = M_z^{(1)}(-\nu)$.) Als eine direkte Folge aus den Gleichungen (25) und (26) stehen die transversalen Komponenten des gemittelten Magnetisierungsvektors nach dem COOP-Pulspaar zueinander in Beziehung:

$$\overline{M}_x(\nu) = \overline{M}_x(-\nu), \qquad (27)$$

$$\overline{M}_y(\nu) = -\overline{M}_y(-\nu). \qquad (28)$$

Dies ist analog zu den Beziehungen in den Gleichungen (22) und (23) für einen phasenalternierenden Einzelpuls und entspricht, wie oben diskutiert, der Symmetrie des Problems. Die Symmetriebeziehungcn für die gemittelten transversalen Magnetisierungskomponenten (Gleichungen (27) und (28)) können immer realisiert werden, wenn die Gruppe von $N$ COOP-Pulsen aus zueinander symmetrischen Pulspaaren (mit den Phasenbeziehungen entsprechend Gl. (24)) und/oder phasenalternierenden Pulsen mit den Phasen $\pm\pi/2$ besteht. Zum Beispiel für $N = 3$ besteht die Gruppe von COOP-Pulsen aus einem zueinander symmetrischen Pulspaar und einem phasenalternierenden Puls (vgl. Fig. 5 C). Für $N = 4$, 5, und 6 finden wir immer zwei zueinander symmetrische Pulspaare und eine entsprechende Anzahl von phasenalternierenden Pulsen.

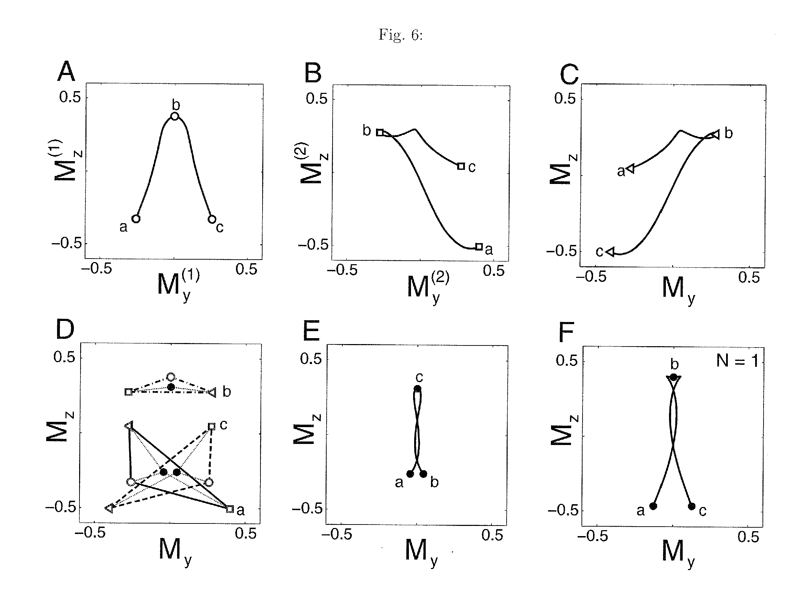

Fig. 6 zeigt die Position der individuellen und der gemittelten Magnetisierungsvektoren in der $y$-$z$-Ebene nach den COOP-Pulsen für $N = 3$ (vgl. Fig. 5 C). Die mit a, b und c bezeichneten Punkte entsprechen den Offsetfrequenzen -20 kHz, 0 kHz und 20 kHz. Die Figuren 6B und C veranschaulichen die Symmetriebeziehungen der Gleichungen (22, 23) und (27, 28). Relativ große $y$-Komponenten bis 40% werden für jeden individuellen Puls gefunden, was die zusätzlichen, durch das COOP-Verfahren gewonnenen Freiheitsgrade verdeutlicht. Die gemittelten Magnetisienmgsvektoren jedoch liegen sehr nahe an der $x$-$z$-Ebene, wie in Fig. 6E gezeigt. In Fig. 6F entsprechen die Ecken der Dreiecke die Positionen der Magnetisierungsvektoren nach den individuellen Pulsen und die Schwerpunkte der Dreiecke zeigen die Positionen der gemittelten Magnetisierungsvektoren für die Offsets -20 kHz (a), 0 kHz (b) und 20 kHz (c), was den Mittelungsprozess veranschaulicht. Zum Vergleich sind in Fig. 6D auch die Positionen der Magnetisierung nach den optimierten Einzelpulsen gezeigt (vgl. Fig. 5 A).

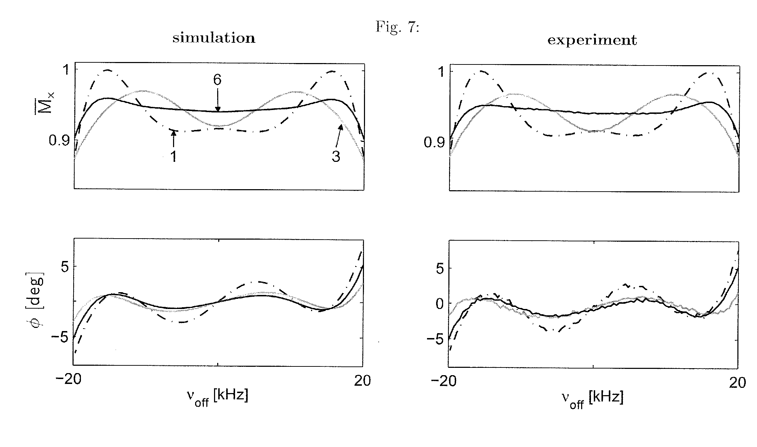

Wie aus Fig. 7, wo die $x$-Komponenten und die Phasen der gemittelten Magnetisierungsvektoren für den optimierten Einzelpuls und die COOP-Pulse mit $N = 3$ und $N = 6$ gezeigt sind, ersichtlich wird eine gute Übereinstimmung für die simulierten und experimentelle Leistung der COOP-Pulse gefunden. Für den Einzelpuls liegt die Anregungseffizienz für einen großen Offsetbereich unter 92%, wohingegen für $N = 6$ die Anregungseffizienz für fast den gesamten Offsetbereich 95% erreicht. Gleichzeitig ist der größte Phasenfehler bei extremen Offsets von 8° auf 5°, und für Offsets zwischen $\pm 18$ kHz von 3° auf weniger als 1.3° reduziert.

Skinner et al. haben in (J. Magn. Reson. 172 (2005) 17-23) für einen Einzelpuls eine konservative untere Grenze von 100 $\mu$z angenommen, damit dieser mehr als 95% Anregungseffizienz und einen Phasenfehler von nicht mehr als 4° mit einer relativen Bandbreite von $\Delta\nu_{off}/\nu_{rf}^{max} = 2.3$ und mit einer RF-Toleranz von $\pm 5\%$ erreicht. Mit dem erfindungsgemäßen COOP-Verfahren, sind wir imstande die untere Grenze bzgl. der Pulsdauer auf 65 $\mu$s für $N = 6$ zu drücken (Ergebnisse nicht gezeigt).

Figur 4 zeigt den Qualitätsfaktor $\Phi$ für Anregung von $x$-Magnetisierung mit Pulsdauern von $T = 50$ $\mu$s als Funktion der Anzahl der COOP-Pulse $N$.

Figur 5 zeigt Anregungspulse mit minimierten Phasenfehlern mit einer Dauer von $T = 50$ $\mu$s: (A) konventioneller Einzelpuls, (B) Gruppe von COOP-Pulsen mit $N = 2$, (C) Gruppe von COOP-Pulsen mit $N = 3$. Für beide Pulspaare mit "glatter" Phasenmodulation in B und C sind die individuellen Pulse zueinander symmetrisch gemäß $\varphi^{(j+1)}(t) = -\varphi^{(j)}(t) - \pi$, was äquvalent ist zu Gl. (24).

Figur 6 zeigt in A - C die individuellen Offsetprofile der Gruppe von drei COOP-Pulsen ($N = 3$) aus Fig. 5. Die Endzustände von $M_y^{(j)}(T)$ und $M_z^{(j)}(T)$ innerhalb eines Offsetbereichs von $\pm 20$ kHz sind gezeigt, wobei in jeder der Figuren die Offsets -20 kHz, 0 kHz und 20 kHz durch Symbole (offene Kreise, Quadrate und Dreiecke) markiert sind. Für diese drei Offsets sind die $y$-und $z$-Komponenten von $\boldsymbol{M}^{(1)}(T)$, $\boldsymbol{M}^{(2)}(T)$ und $\boldsymbol{M}^{(3)}(T)$ (offene Symbole) und von $\overline{\boldsymbol{M}}(T)$ (gefüllte Scheiben) in D gezeigt, wodurch die Auslöschung von Phasenfehlern gezeigt wird. Figur E zeigt die Position des gemittelten Magnetisierungsvektors $\overline{M}(T)$ für den gesamten Offsetbereich von $\pm 20$ kHz. Zum Vergleich sind die Positionen des Magnetisierungsvektors $\boldsymbol{M}(T)$ für den konventionell optimierten Einzelpuls ($N = 1$, vgl. Fig. 5 A) in F gezeigt.

In Figur 7 sind simulierte und experimentelle Offsetprofile für die gemittelte Magnetisierung $\overline{M}_x(T)$ und den Phasenfehler $\phi(T)$ für einen Einzelpuls ($N = 1$, vgl. Fig. 5 A) und Gruppen von COOP-Pulsen mit $N = 3$ (vgl. Fig. 5C) und $N = 6$ gezeigt.

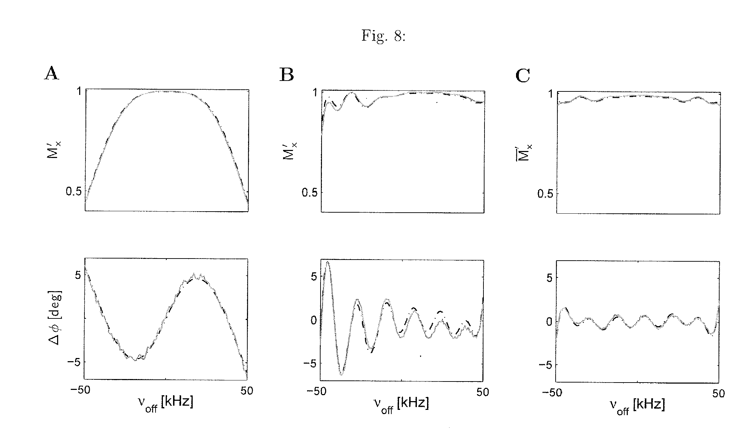

Im vorangehenden Abschnitt war es beabsichtigt Pulse mit Offset-unabhängiger Phase zu erzeugen, d. h. Pulse, bei denen keine Phasenkorrektur erster oder höherer Ordnung nötig ist. Wie Gershenzon et al. in (J. Magn. Reson. 192 (2008) 335-343) zeigen, kann für sogenannte ICEBERG-Pulse (Inherent Coherence Evolution optimized Broadband Excitation Resulting in constant phase Gradients), die transversale Magnetisierung mit einer linearen Abhängigkeit vom Offset erzeugen, eine noch größere Bandbreite erreicht werden. Zum Beispiel ist für einen einfachen Rechteck-90°-Puls die resultierende Phase fast linear für einen großen Offsetbereich und kann mittels Phasenkorrektur erster Ordnung korrigiert werden. Fig. 8 zeigt das Offsetprofil der x-Komponente der $\overline{M}_x(T)$-Magnetisierung und den verbleibenden Phasenfehler nach Phasenkorrektur erster Ordnung mit 2.9°/kHz für einen 14.29 $\mu$s Rechteck-90°-Puls, entsprechend einer RF-Amplitude von $\nu_{rf} = 17.5$ kHz. Über einen Bereich von $\pm 50$ kHz ist der Phasenfehler kleiner als 5°. Jedoch fällt die Anregungseffizienz für Frequenzen außerhalb von $\pm 30$ kHz rapide ab.

Es wurden ein Einzelpuls und eine Gruppe von COOP-Pulsen ($N = 2$) mit einer Dauer von jeweils 60 $\mu$s, einer

maximalen RF-Amplitude von 17.5 kHz, 5% RF-Inhomogenität für eine Bandbreite von $\pm 50$ kHz unter Berücksichtigung der gleichen Phasenkorrektur erster Ordnung von 2.9°/kHz wie für den einfachen Rechteckpuls optimiert. Simulierte und experimentelle Ergebnisse sind in Fig. 8 gezeigt. Die Leistung des optimierten Einzelpulses liegt mit einer transversale Magnetisierung von mehr als 90% (abgesehen von Offsets nahe -50 kHz, wo die Effizienz auf ungefähr 80% abfällt) signifikant über der Leistung des einfachen Rechteckpulses mit 45% und vergleichbaren Phasenfehlern. Trotzdem zeigt die Leistung der erfindungsgemäßen COOP-Pulse eine signifikante weitere Verbesserung mit einer Anregungseffizienz von mehr als 95% und Phasenfehlern von weniger als 2.4° über den gesamten Offsetbereich von $\pm 50$ kHz.

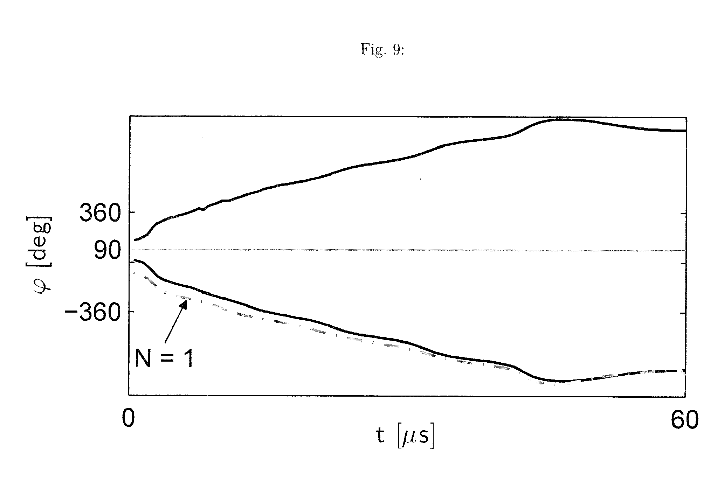

Figur 8 zeigt Offsetprofile für $\overline{M}'x$ und den Phasenfehler $\Delta\phi$ für einen einzelnen Rechteckpuls (A), einen optimierten individuellen COOP ICEBERG-Puls mit $N = 1$ (B, vgl. gestrichpunktete Kurve in Fig. 9) und einer Gruppe von COOP-Pulsen mit $N = 2$ (C, vgl. durchgezogene Kurven in Fig. 9). $\overline{M}'_x$ ist die x-Komponente von $\overline{M}(T)$ und $\Delta\phi$ ist der verbleibende Phasenfehler nach Phasenkorrektur erster Ordnung von 2.9°/kHz. Durchgezogene graue und gestrichpunktete schwarze Kurven stellen experimentelle bzw. simulierte Ergebnisse dar.

Figur 9 Ein einzelner ICEBERG (gestrichpunktete graue Kurven) und eine Gruppe von COOP ICEBERG-Pulsen (durchgezogene schwarze Kurven, $N = 2$). Für das COOP-Pulspaar ist die Symmetriebeziehung aus Gleichung (24) ungefähr erfüllt.

Ein weiteres Beispiel, das die Stärke des erfindungsgemäßen COOP-Verfahrens zeigt, ist durch die WET-Sequenz (Water Suppression Enhanced through $T_1$ Effects) zur Lösemittelunterdrückung von Ogg et al. (J. Magn. Reson. B 104 (1994) 1-10) motiviert. Um auch Lösemittelsignale in größerer Entfernung vom Zentrum der RF-Spule, die daher kleinere RF-Amplituden erfahren, zu unterdrücken, werden Pulse benötigt, die als Breitband-90°-Pulse für die volle RF-Amplitude wirken, aber das Lösemittelsignal in Teilen der Probe, wo die RF-Amplitude signifikant herabskaliert ist, nicht anregen. Zhang et al. (J. Magn. Reson. 143 (2000) 382-386) und Bax (J. Magn. Reson. 64 (1985) 142-145) zeigen, dass eine Lösung auf zusammengesetzten Pulsen, so wie der $90^\circ_x 90^\circ_y 90^\circ_{-x} 90^\circ_{-y}\text{-Puls}$ basiert, der in jedem Scan angewandt wird. Allerdings wurde von Zhang et al. (J. Magn. Reson. 143 (2000) 382-386) in Experimenten mit mehreren Scans eine verbesserte Leistung gefunden, wenn in drei von vier Scans ein einfacher $90^\circ_x\text{-Rechteckpuls}$ verwendet wird und in einem von vier Scans ein einfacher $270^\circ_{-x}\text{-Rechteckpuls}$. Diese Gruppe von vier Pulsen $(90^\circ_x,\ 90^\circ_x,\ 90^\circ_x,\ 270^\circ_{-x})$, die in aufeinanderfolgenden Scans appliziert werden, wurde in J. Magn. Reson. 143 (2000) 382-386 basierend auf der linear-response-Theorie hergeleitet, diese ist jedoch nur für Flipwinkel nahe Null genau gültig. Im Gegensatz dazu erlaubt das hier offenbarte erfindungsgemäße COOP-Verfahren für diese Aufgabe optimierte Gruppen von COOP-Pulsen zu entwickeln, wobei die vollständige nicht-lineare Spindynamik berücksichtigt wird.

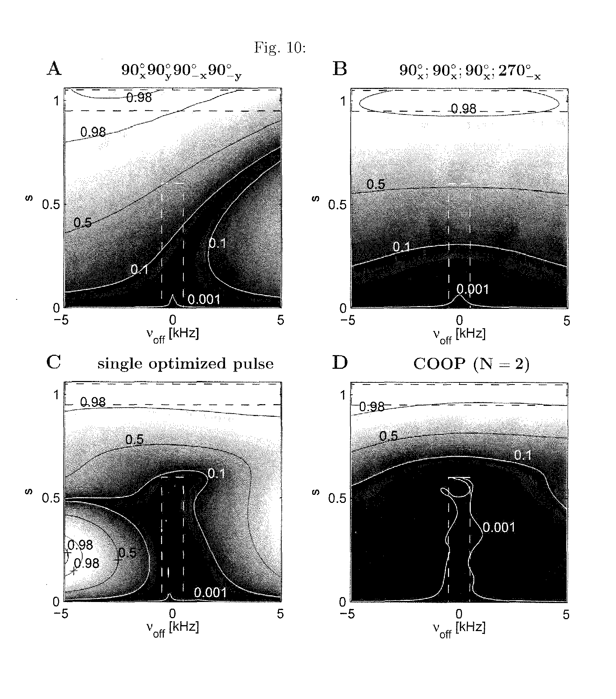

Um dies zu veranschaulichen, wurden entsprechend dem von Kobzar et al. in (J. Magn. Reson. 173 (2005) 229-235) gezeigten Verfahren COOP-Pulse mit einem dem Problem angepassten Anregungsmuster als eine Funktion des Offsets $\nu_{off}$ und des RF-Skalierungsfaktors $s$ optimiert (siehe Fig. 10). Für RF-Skalierungsfaktoren im Bereich von $0.95 \leq s \leq 1.05$ ist das Ziel, $x$-Magnetisierung in einem Offsetbereich von $\pm 5$ kHz mit minimalem Phasenfehler anzuregen. Für RF-Skalierungsfaktoren im Bereich von $0 \leq s \leq 0.6$ ist das Ziel, die transversale Komponente $\overline{M}_\perp = (\overline{M}_x^2 + \overline{M}_y^2)^{1/2}$ des gemittelten Magnetisierungsvektors für einen verringerten Offsetbereich (in der Nähe des Lösemittelsignals) von $\pm 500$ Hz zu minimieren. Wir gehen von anfänglicher z-Magnetisierung und einer maximalen nominellen RF-Amplitude von $\nu_{rf}^{max} = 20$ kHz aus.

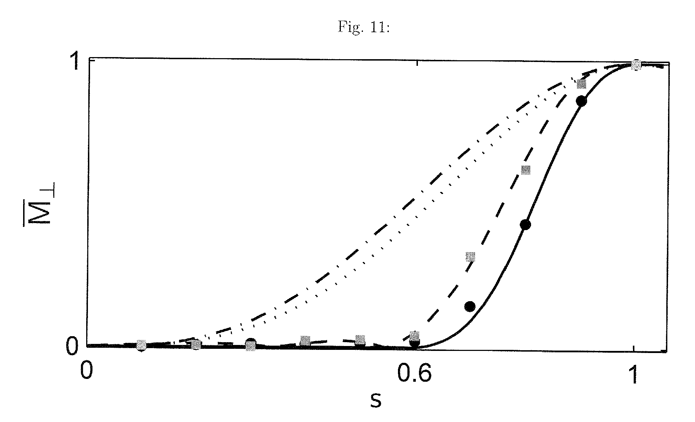

Die Figuren 10 und 11 zeigen die Leistung einer optimierten Gruppe von COOP-Pulsen ($N = 2$) mit einer Dauer von T = 200 $\mu$s für jeden der vier individuellen COOP-Pulse. Zum Vergleich sind auch die Leistung des zusammengesetzten Pulses $90^\circ_x 90^\circ_y 90^\circ_{-x} 90^\circ_{-y}$ aus J. Magn. Reson. 64 (1985) 142-145, einer Sequenz basierend auf $(90^\circ_x,\ 90^\circ_x,\ 90^\circ_x,\ 270^\circ_{-x})$ (aus J. Magn. Reson. 143 (2000) 382-386) und ein optimierter individueller Puls ($N = 1$) gezeigt.

Figur 10 zeigt einen Vergleich der gemittelten transversalen Magnetisierung als Funktion von Offset $\nu_{off}$ und RF-Skalierung s für eine Gruppe von COOP WET-Pulsen (D, $N = 2$) mit dem $90_x 90_y 90_{-x} 90_{-y}$ zusammengesetztem Puls aus J. Magn. Reson. 64 (1985) 142-145 (A), der vier-Scan-Sequenz basierend auf $90^\circ_x; 90^\circ_x; 90^\circ_x; 270^\circ_{-x}$ (B, J. Magn. Reson. 143 (2000) 382-386) und einem optimierten individuellen Puls (C, $N = 1$). Die Bereiche für die optimale Anregung und optimale Unterdrückung der transversalen Magnetisierung gewünscht sind, sind durch schwarze und weiße gestrichelte Rechtecke angezeigt.

Figur 11 zeigt Schnitte aus Fig. 10A (gepunktet), B (gestrichpunktet), C (gestrichelt) und D (durchgezogene Kurve) für den onresonanten Fall. Die grauen Quadrate bzw. schwarzen Scheiben stellen experimentelle Daten für den nach dem Stand der Technik optimierten Puls aus Fig. 10C bzw den erfindungsgemäßen COOP WET-Puls aus Fig. 10D dar.

Ein weiteres Beispiel, das die Vorteile der vorliegenden Erfindung gegenüber dem Stand der Technik zeigt, sind heteronukleare und homonukleare Entkopplung. Das folgende Beispiel zeigt die Vorteile der Erfindung anhand der heteronuklearen Entkopplung, ohne darauf beschränkt zu sein. Die vorliegende Erfindung kann ebenso zur Entwicklung homonuklearer Entkopplungspulse eingesetzt werden. Heteronukleare Entkopplung bedeutet Unterdrückung der heteronuklearen Kopplungsevolution. Ernst et al. zeigen (Principles of nuclear magnetic resonance spectroscopy in one and two dimensions. Clar rendon Press, 1987), dass durch heteronukleare Entkopplung vereinfachte NMR-Spektren erhalten werden können, die einfacher auszuwerten sind, als Spektren, die ohne Entkopplung aufgenommen wurden und zusätzlich durch die höhere Intensität entkoppelter Signale ein verbessertes Verhältnis von Signal zu Rauschen aufweisen. Die dem Stand der Technik entsprechenden Entkopplungssequenzcn führen zu unerwünschten Signalbeiträgen. Unerwünschte Signalbeiträge im Kontext von Entkopplung umfassen Entkopplungseitenbanden sowie Abweichungen von einem gewünschten Offset-Profil. Ein gewünschtes Offset-Profil ist beispielsweise eine konstante und maximale Signal-Amplitude des beobachteten Spins, die unabhängig vom Resonanz-Offset des entkoppelten Spins ist, bei dessen Frequenz die Entkopplungssequenz eingestrahlt wird. Weitere gewünschte Offset-Profile umfassen bandselektive Entkopplung, so wie sie von Eggenberger et al. in J. Magn. Reson 100 (1992) 604-610 und von Zuiderweg et al. in J. Magn. Reson. 93 (1991) 653-658 gezeigt wurde, oder eine definierte Skalierung der Kopplung, so wie sie von Riek et. al in J. Am. Chem. Soc. 125 (2003) 16104-16113 gezeigt wurde. Eine konstante und maximale Signalamplitude als gewünschtes Offsetprofil ist insbesondere für Entkopplungssequenzen relevant, die in der quantitativen NMR-Spektroskopie Anwendung finden sollen.

Ein Verfahren zur Reduktion von Entkopplungsseitenbanden ist das von Kupce im US-Patent US 688348 und von Kupcc et al. in J. Magn. Reson. 151 (2001) 142-145 gezeigte so genannte DESIRE-Verfahren. DESIRE ist ein 2D NMR-Verfahren, bei dem das Spektrum in der direkten Frequenzdimension F2 bezüglich der chemischen Verschiebung aufgelöst ist, so wie es bei einem herkömmlichen Anregungsexperiment der Fall ist. In der indirekten Dimension F1 ist das Spektrum bezüglich der Frequenzaufspaltung der Entkopplungseitenbanden relativ zum jeweiligen Hauptsignal aufgelöst. Das heißt, das Anregungsspektrum entspricht dem Schnitt durch das 2D-Spektrum bei F1 = 0, Signale der Entkopplungsseitenbanden erscheinen bei F1 ≠ 0. Durch dieses Verfahren kann ein Spektrum mit ca. 100-fach reduzierter Intensität der Seitenbanden erhalten werden. Um jedoch eine ausreichende Auflösung in F1 zu erhalten, sind zahlreiche Experimente mit verschiedenen $t_1$-Evolutionszeiten notwendig. (Kupce et al. zeigen in J. Magn. Rcson. 151 (2001) 142-145 Spektren, bei denen 64 bzw. 128 entsprechende Experimente durchgeführt wurden.) Ein Nachteil dieses Verfahrens ist, dass durch DESIRE zwar Seitenbanden, jedoch nicht die Abweichungen von einem gewünschten Anregungs-/Entkopplungsprofil reduziert werden. Zusätzlich wird bei DESIRE nicht die Möglichkeit genutzt, dass sich die durch die Entkopplungspulse der verschiedenen Scans erzeugten unerwünschten Signalbeiträge auslöschen können. Kupce et al. zeigen in J. Magn. Reson. 122 (1996) 81-84 ein Verfahren zur Reduktion von Entkopplungsseitenbanden, bei dem sich die durch die Entkopplungspulse der verschiedenen Scans erzeugten unerwünschten Signalbciträge auslöschen können. Dabei wird in einem ersten Scan ausschließlich mit niedriger Leistung entkoppelt ("low-level decoupling"). In allen darauf folgenden Scans erfolgt zunächst Entkopplung mit hoher Leistung ("highlevcl decoupling") gefolgt von Entkopplung mit niedriger Leistung entkoppelt ("low-level decoupling"). Dabei wird die Dauer der Entkopplung mit hoher Leistung mit jedem folgenden Scan schrittweise verlängert. Dadurch gelingt es, die durch die Entkopplungspulse der verschiedenen Scans erzeugten unerwünschten Signalbeiträge teilweise auszugleichen. Eine Weiterentwicklung dieses Verfahrens für die Polymeranalytik wurde von Zhou et al. in J. Magn. Reson. 187 (2007) 225-233 gezeigt. Durch das bilevel-Entkopplungsverfahren ist eine deutliche Reduktion der Entkopplungsseitenbanden möglich. Nachteile des Verfahrens sind die hohen rf-Intensitäten während der Entkopplung mit hoher Leistung sowie die fehlende Unterdrückung von Abweichungen von einem gewünschten Offsetprofil.

Das von Neves et al. J. Magn. Rcson. 201 (2009) 7-17 gezeigte GRAPEtracking Verfahren ermöglicht die numerische Optimierung nicht-periodischer Entkopplungssequenzen für einen Scan. Durch das GRAPE-tracking-Verfahren konnten breitbandige Entkopplungspulse für in vivo-Anwendungen, die eine niedrige rf-Intensität benötigen, optimiert werden. Die gefundenen Ergebnisse übertreffen deutlich die Qualität existierender Verfahren. Die Möglichkeit, unerwünschte Signalbeiträge über mehrere Scans herauszumitteln, wurde hier bisher jedoch nicht genutzt.

Wie von Akoka et al. in J. Magn. Reson. 185 (2007) 50-58 gezeigt, erzeugen herkömmliche Entkopplungssequenzen zu große Abweichungen von einem gewünschten Offset-Profil, um in der quantitativen NMR eingesetzt werden zu können. Ein vorteilhaftes gewünschtes Offset-Profil für die quantitative NMR ist eine konstante und maximale Signal-Amplitude. Akoka et al. zeigen an der selben Stelle, wie diese Abweichungen, die unerwünschte Systemzustände sind, durch Verwendung spezieller adiabatischer Entkopplungssequenzen reduziert werden können. Dieses Verfahren berücksichtigt jedoch nicht die Möglichkeit in mehreren Scans verschiedene Pulse anzuwenden und ist zudem auf Entkopplungscquenzen beschränkt, die aus Folgen von adiabatischen Inversionspulsen aufgebaut sind. Darüber hinaus sind für die von Akoka et al. in J. Magn. Reson. 185 (2007) 50-58 gezeigten Entkopplungssequenzen hohe RF-Amplituden erforderlich.

Das erfindungsgemäße COOP-Verfahren ermöglicht die simultane Optimierung von Entkopplungspulsen, die ihre Fehler ausgleichen. Dadurch können sowohl unerwünschte Singalbeiträge, wie beispielsweise Entkopplungsseitenbanden und/oder Abweichungen von einem gewünschten Offsetprofil eliminiert werden. Ein beispielhafter Qualitätsfaktor für die Optimierung von COOP-Entkopplungspulsen ist

$$\Phi_{Entkopplung} = \frac{1}{N_\epsilon N_\nu} \sum_{p=1}^{N_\epsilon} \sum_{q=1}^{N_\nu} \phi, \qquad (29)$$

wobei $N_\epsilon$ der Anzahl der berücksichtigten RF-Skalierungsfaktoren s entspricht, $N_\nu$ der Anzahl der berücksichtigten Offsetfrequenzen $\nu_{off}$. Die COOP-Entkopplungssequenz wird dabei in $N_{acq}$ Akquisitionspunkte unterteilt. Ein mögliches Maß für die Qualität der erfindungsgemäßen COOP-Entkopplungssequenz am $k$-ten Akquisitionspunkt für $N$ COOP-Pulse ist abhängig vom Erwartungswert für $I_x$:

$$\overline{s}_k = \overline{\langle I_x \rangle} = \frac{1}{N} \sum_{j=1}^{N} \langle I_x^{(j)} \rangle. \qquad (30)$$

Vorteilhaft für das erfindungsgemäße Verfahren ist beispielsweise die Verwendung von

$$1 - a(1 - \overline{s}_k)^n \qquad (31)$$

als Maß für die Qualität der erfindungsgemäßen COOP-Entkopplungssequenz am $k$-ten Akquisitionspunkt für $N$ COOP-Pulse, wobei $n$ eine geradzahlig, ganze Zahl ist, vorzugsweise ist $n = 2$ und wobei $a$ ein reeler, positiver Skalierungsfaktor ist.

Somit ergibt sich in diesem Beispiel für $\phi$ in Gleichung 29:

$$\phi = \frac{1}{N_{acq} + 1} \sum_{k=0}^{1} (1 - (1 - \overline{s}_k)^n) \exp\{-\kappa T_k\} \qquad (32)$$

Darin sind wie von Neves et al. in J. Magn. Reson 201 (2009) 7-17 gezeigt, Relaxationseffekte durch den Term $\exp\{-\kappa T_k\}$ berücksichtigt. Somit ergibt sich in diesem Beispiel für den Costate des $j$-ten COOP-Entkopplungspulses zur Zeit des $k$-ten Akquisitionspunktes $T_k$

$$\lambda_k^{(j)}(T_k) = \frac{\partial \phi}{\partial I_x^{(j)}(T_k)} = \frac{n}{N_{acq} + 1}(1 - \overline{s}_k) \exp\{-\kappa T_k\} I_x \qquad (33)$$

Analog zu den bereits gezeigten Beispielen ist am Akquisitionspunkt $T_k$ $\lambda_k^{(j)}(T_k)$ für alle COOP-Pulse identisch, wird jedoch individuell entsprechend des $j$-ten COOP-Entkopplungspulses rückwärtspropagiert. Im Gegensatz zu den vorhergehenden Beispielen ist hier der Qualitätsfaktor $\Phi$ nicht nur von den $N$ Endzuständen des Systems am Ende der $N$ COOP-Pulse, sondern von den Systemzuständen zu den Zeiten $T_k$ aller $N_{acq}$ Akquisitionspunkte aller $N$ COOP-Pulse abhängig.

Der Gradient für die Qualitätsfunkton $\Phi$ für das $l$-te Pulsinkrement des $j$-ten COOP-Pulses ist in diesem Beispiel

$$\frac{\delta\Phi}{\delta u_\alpha^{(j)}(l)} = \frac{1}{N_\epsilon N_\nu} \sum_{p=1}^{N_\epsilon} \sum_{q=1}^{N_\nu} \frac{\delta\phi(\epsilon^{(p)}, \nu_{off}^{(q)})}{\delta u_\alpha^{(j)}(l)}, \qquad (34)$$

wobei $\epsilon$ der rf-Skalierungsfaktor und $\alpha = x$ oder $\alpha = y$ oder $\alpha = z$, wobei im vorliegenden Beispiel $\alpha = x$ oder $\alpha = y$ sein kann. Zusätzlich gilt in diesem Beispiel

$$\frac{\delta\phi}{\delta u_\alpha^{(j)}(l)} = -2i\pi\epsilon\Delta t \sum_{k>m} \lambda_k^{(j)}(t_l) \left[ I_\alpha, \rho_l^{(j)} \right] \qquad (35)$$

wobei $m = \lfloor l/M \rfloor$ und $M$ die Anzahl der Pulsinkremente zwischen zwei Akquisitionspunkten und $t_l$ der Zeitpunkt ist, an dem das $l$-te Pulsinkrement angewendet wird. Die Dauer eines Pulsinkrementes wird in diesem Beispiel konstant gewählt und beträgt $\Delta t$, wobei das erfindungsgemäße Verfahren nicht auf konstante Werte für $\Delta t$ beschränkt ist.

Bisher haben wir nur Beispiele betrachtet, in denen COOP-Pulse in *mehreren* Scans an einer *einzigen* Stelle einer Pulssequenz angewandt wurden, was das Konzept des Phasenzykeln verallgemeintert bzw. ergänzt. Jetzt wenden wir uns einer Ausführungsform der Erfindung zu, bei der COOP Pulse in einem *einzigen* Scan und an *unterschiedlichen* Stellen der Pulssequenz eingesetzt werden. Die vorliegende Erfindung ist jedoch nicht darauf beschränkt, dass bei der Optimierung mehrerer Pulse eines Scans nur die Pulse, die in einem einzelnen Scan angewendet werden, gleichzeitig optimiert werden. D. h. in einem ein- oder mehrdimensionalen Experiment, umfassend $M$ rf-Pulse und $N$ Scans können $MN$ rf-Pulse optimiert werden.

Die von Morris und Freeman (J. Am. Chem. Soc. 101 (1979) 760-762) gezeigte INEPT (Insensitive Nuclei Enhanced Polarization Transfer)-Sequenz wird hier als Anwendungsbeispiel betrachtet, einen zentralen Baustein vieler NMR-Experimente.

Die INEPT-Sequenz dient dem Polarisationstransfer zwischen zwei gekoppelten Spins. Der von Sørensen et al. gezeigte (Prog. NMR Spectrosc. 16 (1983), 163-192) Produktoperatorformalismus kann dazu verwendet werden, die dem Stand der Technik entsprechende INEPT-Sequenz für ein Zweispinsystem wie folgt zusammenzufassen:

$$I_z \xrightarrow{\;(a)\; PP_{z\to x}(I)\;} I_x \xrightarrow[\text{für } t=1/(2J)]{\;(b)\; \text{Kopplungsevolution}\;} 2I_y S_z \xrightarrow[PP_{z\to y}(S)]{\;(c)\; PP_{y\to z}(I)\;} -2I_z S_y \quad (36)$$

(a) Ausgehend von z-Magnetisierung wird mittels eines PP (point-to-point)-Pulses auf den $I$-Spin x-Magnetisierung erzeugt. (b) Danach wird während einer Zeit, die idealerweise $1/(2J)$ ist, nur Kopplungsevolution zugelassen, damit sich der Antiphase-Operator $2I_y S_z$ entwickelt. (Chemische Verschiebungsevolution wird in der Regel entweder durch einen 180° UR (unitary rotation)-Puls auf Spin I und S nach der halben Evolutionszeit, nämlich $1/4J$ refokussiert. Wie von Hwang et al. (J. Magn. Reson. A 112 (1995)) und Adams (Magn. Reson. Chem. 46 (2008), 377-380) gezeigt, können alternativ auch PP-Inversionspulse, jeweils auf I und S, nach $1/8J$ und $3/8J$ verwendet werden. Auf diesen Fall beziehen wir uns im Folgenden.) (c) Als letztes wird mittels zweier PP-Pulse die Kohärenz von Spin $I$ auf $S$ übertragen. Als PP- und UR-Pulse können einfache Rechteckpulse wie auch zusammengesetzte und geformte Pulse verwendet werden.

Anders als der Stand der Technik fordert, ist es prinzipiell nicht notwendig, dass zu Beginn und am Ende der Kopplungsevolution (b) alle Spins eines bestimmten Offsetbereichs bezüglich $I$ die gleiche Phase aufweisen. Es genügt, wenn die beiden Pulse vor und nach der Kopplungsevolutionszeit (b) konzertiert zunächst den anfänglichen $I_z$-Operator vollständig in transversale In-Phase-Operatoren der Form $I_\phi = \cos(\phi)I_x + \sin(\phi)I_y$ überführen, wobei $\phi$ beliebig mit dem Offset variierten kann, und im Fall von zwei PP(180°)-Pulsen für die Refokussierung der chemischen Verschiebung am Ende von (b) die Antiphase-Opcratoren der Form $2I_{\phi+90°}S_z = \cos(\phi + 90°)2I_x S_z + \sin(\phi+90°)2I_y S_z$ vollständig in $2I_z S_z$ überführen. Die gewünschte Antiphase-Kohärenz auf Spin $S$ kann danach mit beliebiger Phase durch einen herkömmlichen PP-Puls auf $S$ erzeugt werden.

Dieses Problem lässt sich auf den Fall eines Ensembles ungekoppelter Spins reduzieren, das sich mit den Bloch-Gleichungen (Gl. (4)) beschreiben lässt. Wir gehen von anfänglicher z-Magnetisierung aus, die konzertiert von einem ersten Puls zunächst in transversale Magnetisierung $M_\phi = \cos(\phi)M_x + \sin(\phi)M_y$ überführt und direkt danach von einem zweiten Puls zurück zur z-Achse rotiert wird. (Die Phasendifferenz von 90°, die die Antiphaseoperatoren am Ende von (b) gegenüber den In-Phase-Operatoren zu Beginn von (b) aufweisen, kann in unserem vereinfachten Modell durch Addition von 90° zur Gesamtphase des zweiten Pulses berücksichtigt werden.)

Um zwei derartige erfindungsgemäße COOP-Pulse zu konstruieren, optimieren wir zunächst eine Gruppe von zwei COOP-Pulsen mit folgendem für den Fachmann nicht naheliegenden Qualitätsfaktor:

$$\Phi_d = M_x^{(1)}(T) \cdot M_x^{(2)}(T) - M_y^{(1)}(T) \cdot M_y^{(2)}(T), \qquad (37)$$

womit die End-Costate-Vektoren gegeben sind $\boldsymbol{\lambda}^{(1)}(T) = (M_x^{(2)}, -M_y^{(2)}, 0)^t$ durch und $\boldsymbol{\lambda}^{(2)}(T) = (M_x^{(1)}, -M_y^{(1)}, 0)^t$. Die mit diesem Qualitätsfaktors erhaltenen Individuen der zwei COOP-Pulse maximieren beide die transversale Magnetisierung mit der Randbedingung

$$M_x^{(1)}(\nu) = M_x^{(2)}(\nu), \qquad (38)$$

$$M_y^{(1)}(\nu) = -M_y^{(2)}(\nu). \qquad (39)$$

D. h. idealerweise sind die Endmagnetisierungsvektoren der zwei COOP-Pulse symmetrisch zur x-Achse, womit man die Gleichungen (38) und (39) zusammenfassen kann: $M^{(1)}(\nu) = U_x(\pi)\, M^{(2)}(\nu)\, U_x^{-1}(\pi)$, wobei die unitäre Transformation $U_k(a) = \exp\{-i\alpha I_k\}$ einer Rotation um $\alpha$ um die $k$-Achse ($k$ ist $x,y$ oder $z$) entspricht. Folglich sind die effektiven Propagatoren $W^{(j)}(\nu)$ der Individuen der Gruppe von COOP-Pulsen symmetrisch zu einer Achse in der transversalen Ebene, die konstant ist, in diesem beispielhaften Fall die $y$-Achse, d. h.

$$W^{(1)}(\nu) = U_y(\pi)\, W^{(2)}(\nu)\, U_y^{-1}(\pi), \qquad (40)$$

denn die Propagatoren sind relativ zu den Endmagnetisierungsvektoren um 90° phasenversetzt.
Die von Luy et al. gezeigte Beziehung aus (J. Magn. Reson. 176 (2005), 179-186) nutzen wir, um schließlich das erfindungsgemäße COOP-INEPT-Pulspaar zu erhalten:

$$\overline{W}^{tr}(\nu) = U_y(\pi)\, \overline{W}^{-1}(\nu)\, U_y^{-1}(\pi), \qquad (41)$$

wobei $\overline{W}^{tr}(\nu)$ der phasen- und zeitinvertierte Propagator des Pulses W ist. Daraus erhalten wir

$$\begin{aligned}
\left[\overline{W}^{(1)}(\nu)\right]^{tr} &= U_y(\pi)\, \left[W^{(1)}(\nu)\right]^{-1}\, U_y^{-1}(\pi) \\
&= U_y(\pi)\, \left\{U_y(\pi)\, \left[W^{(2)}(\nu)\right]^{-1}\, U_y^{-1}(\pi)\right\}\, U_y^{-1}(\pi) \\
&= W^{(2)}(\nu)^{-1} \qquad\qquad (42)
\end{aligned}$$

Es ist einfach zu zeigen, dass ebenso gilt $[\overline{W}^{(2)}(\nu)]^{tr} = W^{(1)}(\nu)^{-1}$. Somit lässt sich aus jeweils einem der beiden Individuen der Gruppe von COOP-Pulsen durch Zeit- und Phaseninversion der inverse Propagator des anderen Individuums konstruieren. Um den für die erfindungsgemäße COOP INEPT-Sequenz benötigten Puls nach der Evolutionszeit (b) zu erhalten ist es nur noch notwendig, 90° zur Gesamtphase des zeit- und phaseninvertierten Pulses zu addieren.
COOP-INEPT-Pulse können durch kooperatives Zusammenwirken ohne jegliche Einschränkung bzgl. der Phase $z$-Magnetisierung in die transversale Ebene und wieder zurück zur $z$-Achse bringen, was der INEPT-Sequenz zusätzliche Freiheitsgrade verleiht und die Optimierung robusterer und breitbandigerer Pulse erlaubt.

Bei einer weiteren bevorzugten Ausführungsform der Erfindung kombinieren wir in einer für den Fachmann nicht naheliegenden Weise die Prinzipien der COOP-INEPT-Pulse mit dem ICEBERG-Prinzip aus (J. Magn. Reson. 192 (2008) 335-343). Aufgrund der Äquivalenz von chemischer Verschiebungs- und heteronuklearer Kopplungevolution genügt es in diesem Fall, ein Ensemble von ungekoppelten Spins bei verschiedenen Offsets zu betrachten. Herkömmliche Anregungspulse erzeugen idealerweise transversale Magnetisierung mit einheitlicher Phase. (So rotiert z. B. ein idealer $PP_{z \to x}$-Anregungspuls die Magnetisierung für alle gewünschten Offsets von der $z$- zur $x$-Achse.) ICEBERG-Anregungspulse hingegen erzeugen transversale Magnetisierung mit linearer Abhängigkeit der Phase vom Offset. Die Beziehung zwischen der bereits vorgestellten COOP-INEPT-Variante und ihrer ICEBERG-Modifikation ist analog. So müssen zur Konstruktion zweier COOP-INEPT-Pulse zunächst zwei Pulse optimiert werden, die transversale Magnetisierung erzeugen, wobei die Endmagnetisierungsvektoren des ersten und zweiten Pulses für alle betrachteten Offsets idealerweise in der transversalen Ebene liegen und bei gleicher Offsetfrequenz symmetrisch zur $x$-Achse sind (s. o.). Bei der ICEBERG-Modifikation des COOP-INEPT-Verfahrens wird ebenso transversale Magnetisierung erzeugt, wobei hier jedoch für identische Offsets die Endmagnetisierungsvektoren zu einer Achse in der transversalen Ebene symmetrisch sind, deren Phase $\phi$ linear vom Offset abhängt:

$$\boldsymbol{M}^{(1)}(\nu) = U_\phi(\pi)\ \boldsymbol{M}^{(2)}(\nu)\ U_\phi^{-1}(\pi), \qquad (43)$$

wobei $U_\phi(\pi) = \exp\{-i\pi I_{(C \cdot x + S \cdot y)}\}$ mit $C = \cos(\phi) = \cos(2\pi\ \nu_{off}\ RT)$ und $S = \sin(2\pi\ \nu_{off}\ RT)$. $R$ ist der sogenannte R-Faktor, wie er von Gershenzon et al. in (J. Magn. Reson. 192 (2008) 335-343) definiert wurde.

Um zwei derartige Pulse optimieren zu können, definieren wir den Qualitätsfaktor

$$
\begin{aligned}
\Phi_e \;=\; & \left\{ M_x^{(1)}(T)M_x^{(2)}(T) - M_y^{(1)}(T)M_y^{(2)}(T) \right\} \cdot (C^2 - S^2) \qquad (44) \\
& + 2\left\{ M_x^{(1)}(T)M_y^{(2)}(T) + M_y^{(1)}(T)M_x^{(2)}(T) \right\} \cdot (CS).
\end{aligned}
$$

Damit erhalten wir für die End Costate-Vektoren

$$
\boldsymbol{\lambda}^{(1)}(T) \;=\; \begin{pmatrix} (C^2 - S^2) \cdot M_x^{(2)}(T) + 2CS \cdot M_y^{(2)}(T) \\ -(C^2 - S^2) \cdot M_y^{(2)}(T) + 2CS \cdot M_x^{(2)}(T) \\ 0 \end{pmatrix} \qquad (45)
$$

und

$$
\boldsymbol{\lambda}^{(2)}(T) \;=\; \begin{pmatrix} (C^2 - S^2) \cdot M_x^{(1)}(T) + 2CS \cdot M_y^{(1)}(T) \\ -(C^2 - S^2) \cdot M_y^{(1)}(T) + 2CS \cdot M_x^{(1)}(T) \\ 0 \end{pmatrix} \qquad (46)
$$

Nach der Optimierung mit diesem Qualitätsfaktor wird wie bei dem bereits diskutierten COOP-INEPT-Verfahren einer der beiden Pulse unverändert als erster COOP-INEPT-ICEBERGPuls verwendet und ein zweiter der beiden Pulse phasen- und zeitinvertiert und als zweiter COOP-INEPT-ICEBERG-Baustein verwendet.

Der Hauptunterschied zum zuvor diskutierten COOP-INEPT-Verfahren besteht darin, dass die Endmagnetisierungsvektoren bei der Optimierung der ICEBERG-Variante so definiert werden, so dass für eine Zeit $T' = RT$ während des Pulses freie Evolution wirkt. D. h. der Endzustand nach dem ersten COOP-INEPT-ICEBERG-Puls entspricht dem Zustand nach einem gewöhnlichen COOP-INEPT-Puls und einer freien Evolutionszeit *T'*. Somit verkürzt sich für die ICEBERG-Variante der COOP-INEPT-Sequenz die erste freie Evolutionszeit von $1/(8J)$ auf $1/(8J) - T'$. (Daher ist der maximale Wert für *T'* auf $1/(8J)$ festgelegt.) Analog dazu muss in unserer INEPT-Sequenz der zweite ICBERG-Puls eine Zeit *T'* früher einsetzen, als dies bei einem vergleichbaren gewöhnlichen zweiten COOP-INEPT-Puls der Fall wäre.

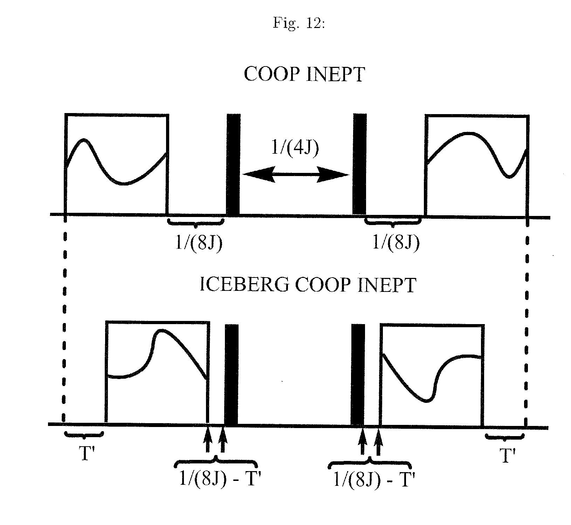

Somit liegt der besondere Vorteil der ICEBERG-Variante des COOP-INEPT-Verfahrens darin, dass sich die Gesamtdauer des ICEBERG-INEPT-Blocks gegenüber der Dauer eines gewöhnlichen COOP-INEPT-Blocks mit gleichen Pulsdauern *T* für die ICEBEG-Variante um 2*T'* verkürzt (siehe Fig. 12). Somit kann ein INEPT-Block mit kürzerer Gesamtdauer und vergleichbarer Güte oder gleicher Dauer und größerer Robustheit bzgl. Offset und RF-Inhomogenität erzeugt werden.

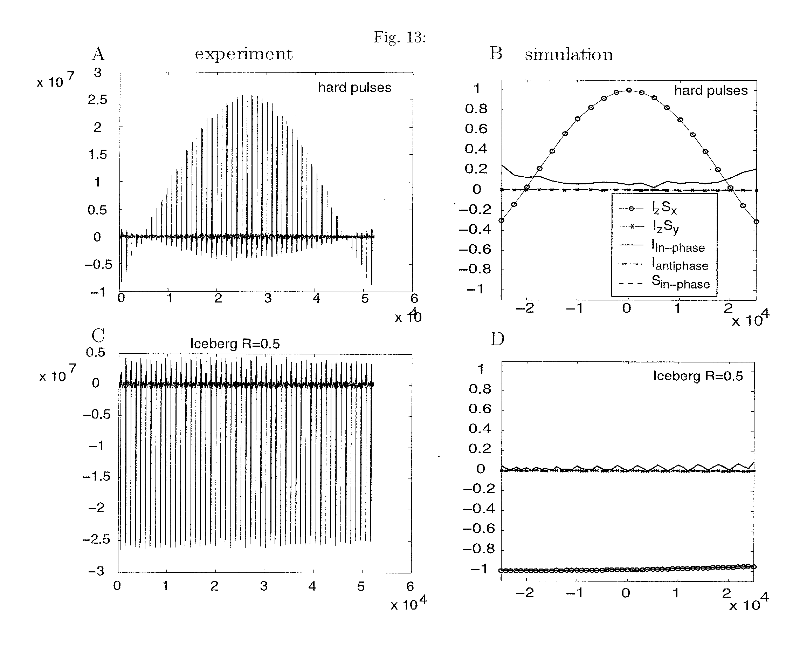

In Fig. 13 werden simulierte (B, D) und experimentelle (A, C) Resultate der erfindungsgemäßen COOP-INEPT-ICEBERG-Technik (C, D) mit dem Stand der Technik (A, B) verglichen. Die beiden getesteten Pulssequenzen sind in Fig. 12 dargestellt. Die Sequenz gemäß dem Stand der Technik erzeugt nur für einen schmalen Offsetbereich die gewünschte Antiphasemagnetisierung, wohingegen für Offsets außerhalb von $\pm 10$ kHz die Kohärenztransfereffizienz stark abfällt. Bei der erfindungsgemäßen Sequenz wird für den gesamten Offsetbereich gute Kohärenztransfereffizicnz beobachtet.

Figur 12 zeigt einen Vergleich der beiden COOP-INEPT Varianten. Bei COOP-Pulsen gleicher Länge reduziert sich die Dauer der ICEBERG-Sequenz um $T' = R \cdot T$. Es sind nur die Pulssequenzen für den Kanal auf Spin *I* dargestellt. PP-Inversionspulse auf Spin *S* erfolgen zeitgleich oder unmittelbar nach den PP-Inversionspulsen auf Spin *I*. Nach dem letzten COOP-Puls erfolgt ein 90°-Puls auf *S*.

Figur 13 zeigt experimentelle (C) und simulierte (D) Resultate für ein COOP-INEPT-ICEBERG-Pulspaar mit einer Dauer von 200 $\mu$s und einer maximalen RF-Amplitude von 10 kHz. Für einen Offsetbereich von 50 kHz und eine Robustheit bzgl. der RF-Amplitude von $\pm 5\%$ wird sehr guter Kohärenztransfer beobachtet. Zum Vergleich sind Experiment und Simulation für Rechteck-Pulse mit $T = 25$ $\mu$s gezeigt. Hier fällt die Kohärenztransfereffizienz für Offsetfrequenzen außerhalb von $\pm 10$ kHz rapide ab. Die zugrundeliegende Pulssequenz ist in Fig. 12 gezeigt. Obwohl die beiden COOP-INEPT-ICEBERG-Pulse zusammen insgesamt 350 $\mu$s länger sind als die beiden Rechteckpulse, ist die Gesamtdauer der COOP-INEPT-Sequenz nur um 150 $\mu$s gegenüber der Rechteckpulsvariante erhöht (vgl. Fig. 12).

Die vorliegende Erfindung, ist nicht auf die Optimierung von Pulsen für INEPT-artige Sequenzen beschränkt.

Bei einer bevorzugten Ausführungsform der Erfindung werden Pulse, die die $t_1$-Periode eines NOESY-artigen Experimentes frankieren, optimiert. Das Verfahren ist dabei analog zum gezeigten COOP-INEPT-Verfahren, wobei hier der letzte Schritt der Phasenverschiebung des zweiten Pulses um 90° entfällt. Ebenso kann gemäß der vorliegenden Erfindung Pulse optimiert werden, die die $t_1$-Periode eines COSY-artigen Experimentes flankieren.

Die vorliegende Erfindung betrifft das Konzept von simultan optimierten Pulsen, die auf kooperative Weise wirken und ihre Fehler gegenseitig ausgleichen. D. h. die Erfindung betrifft allgemein Pulse, die im Zusammenspiel bessere Eigenschaften haben können als einzelne Pulse. Insbesondere betrifft die Erfindung simultan optimierte Pulse, die kooperativ wirken, d. h. deren gemittelter Effekt erwünschte Eigenschaften hat oder deren Systemantwort in einer gewünschten Relation zueinander steht. Das heißt, dass im Gegensatz zu konventionellen Ansätzen die einzelnen Pulse diese Eigenschaften nicht (oder nicht in der erforderlichen Güte) haben müssen und z. B. in dem Mittelungs-Prozess die Pulse ihre Fehler gegenseitig kompensieren können. Im einfachsten Fall bezieht sich die Mittelung auf eine zeitliche Mittelung der Signale (FIDs) mehrerer Experimente (Scans). Wie im Fall der COOP-INEPT-Sequenz muss aber keine wirkliche Mittelung erfolgen und die Kooperativität der Pulse besteht darin, dass die jeweilige Effekte der einzelnen Pulse in einer erwünschten Relation zueinander stehen.

Obwohl der Einfachheit halber nur Beispiele mit ungekoppelten Spins betrachtet wurden, ist es wichtig zu erwähnen, dass das erfindungsgemäße COOP-Verfahren ebenso für gekoppelte Spinsysteme angewandt werden kann. Sørensen et al. zeigen (Prog. NMR Spectrosc. 16 (1983), 163-192), wie derartige Spinsysteme mithilfe des Produktoperatorformalismus' beschrieben werden können. Ein anderes Verfahren zur Beschreibung von gekoppelten Mehrspinsystemen ist der von Ernst et al. gezeigte (Principles of nuclear magnetic resonance spectroscopy. Clarendon Press, 1987) Dichteoperatorformalismus, wobei Ernst et al. ebenso zeigen (Principles of nuclear magnetic resonance spectroscopy. Clarendon Press, 1987), wie Relaxation im Dichteoperatorformalismus berücksichtigt werden kann. Mithilfe verallgemeinerter, auf Optimal-Control basierender Algorithmen, so wie die erfindungsgemäße Variante des GRAPE (Gradient Ascent Pulse Engineering) Algorithmus', können COOP-Pulse effizient optimiert werden.

Weitere Systeme und Experimente, für die das erfindungsgemäße Verfahren angewandt werden kann, umfassen reine Quantenzustände, die beispielsweise durch die zeitabhängige Schrödiziger-Gleichung beschrieben werden können sowie Entkopplungsexperimente, die beispielsweise durch eine Bewegungsgleichung für reelle vier-dimensionale Zustandsvektoren effiziente beschrieben werden können, so wie es von Neves et al. in "Heteronuclear Decoupling by Optimal Tracking", J. Magn. Reson. 201, 7-17 (2009) gezeigt wurde. Darüber hinaus kann das erfindungsgemäße Prinzip der simultanen Optimierung kooperativ wirkender Pulse nicht nur als Gradienten-basiertes Verfahren implementiert werden, sondern ebenso auf andere Optimierungsverfahren übertragen werden, wie zum Beispiel Krotov-Verfahren, wie sie beispielsweise von Krotov et al. (Eng. Cybern. 21, 123 (1983), Russian original: Izv. Akad. Nauk. SSSR Tekh. Kibern. 52 (1983), 162167), von Konnov et al. (Autom. Remote Control 60, 1427 (1999), Russian original: Avtom.

Telemekh. 1999, 7788), von Palao et al. (Phys. Rev. Lett. 89, 188301 (2002) und von Palao et al. (Phys. Rev. A 68, 062308 (2003)) gezeigt wurden, monoton konvergente Verfahren, wie sie beispielsweise von Maday et al. ("New formulation of monotonically convergent quantum control algorithm", J. Chem. Phys. 118 (2003) 81918196) und von Zhu et al. ("A rapid monotonically convcrgent algorithm for quantum optimal control over the expectation value of a denite operator" J. Chem. Phys., 109:385391, 1998) gezeigt wurden, sowie Kombinationen davon wie sie beispielsweise von Machnes et al. ("Comparing, Optimising and Benchmarking Quantum Control Algorithms in a Unifying Programming Framework", Phys. Rev. A, in press (2011)) und Eitan et al. (" Optimal control with accclerated convergence: Combining the Krotov and quasi-Newton methods", Phys. Rev. A 83, 053426 (2011)) gezeigt wurden, sowie Verfahren, wie sie von Tannor et al. ("Time Dependent Quantum Molecular Dynamics" , chapter Control of photochemical branching: Novel procedures for finding optimal pulses and global upper bounds, pages 347-360. Plenum, 1992) gezeigt wurden. Bisher wurde die Erfindung anhand des GRAPE-Verfahrens gezeigt, bei dem in einem Iterationsschritt skalierte oder nichtskalierte Gradienten zu allen Kontrollen addiert werden. Erfindungsgemäße Verfahren sind auch solche Verfahren, bei denen in einem Iterationsschritt zu weniger als allen Kontrollen skalierte oder nicht-skalierte Gradienten addiert werden. So kann/können beispielsweise für beliebig viele Iterationsschritte nur zu einer oder mehreren Kontrollen Gradienten addiert werden, bis ein beliebiges Konvergenzkriterium erfüllt ist oder eine bestimmte Zahl an Iterationen überschritten wurde, wonach für beliebig viele weitere Iterationsschritte zu einer oder mehreren Kontrollen Gradienten addiert werden, bis ein beliebiges Konvergenzkriterium erfüllt ist oder eine bestimmte Zahl an Iterationen überschritten wurde, wobei die letztgenannte(n) Kontrolle(n) ganz oder teilweise identisch mit oder verschieden von der/den Kontrolle(n) der vorhergehenden Iterationsschritte sein können.

Wie für den Fall von COOP-INEPT-Sequenzen gezeigt, ist das COOP-Verfahren nicht auf Experimente mit mehreren Scans beschränkt. In Experimenten, bei denen die verschiedenen Elemente einer Gruppe von COOP-Pulsen in verschiedenen Scans verwendet werden, kann das COOP-Verfahren als Ergänzung und/oder Verallgemeinerung des von Keeler, Bodenhausen, Kogler, Ernst, Bain, Levitt, Madhu und Hughes gezeigten (Understanding NMR Spectroscopy, Wiley, Chichester, 2005; J. Magn. Reson. 58 (1984) 370-388; J. Magn. Reson. 56 (1984) 418-427; J. Magn. Reson. 155 (2002) 300-306) Phasenzykeln und der Differenzspektroskopie (wie z. B. in Principles of nuclear magnetic resonance spectroscopy. Clarendon Press, 1987 beschrieben betrachtet werden.

Im konventionellen Phasenzykeln, werden in jedem Scan - abgesehen von einem Gesamtphasenunterschied - identische Pulse eingesetzt. Bei den Pulsen zur vollständigen Eliminierung von Magnetisierung (s. o.) bestand die optimale Gruppe von COOP-Pulsen ebenso aus Pulsen, die - bis auf einen Gesamtphasenunterschied - identisch waren. Daher ist es möglich mittels des COOP-Verfahrens automatisch Phasenzykeln zu erzeugen. Es ist jedoch wichtig zu erwähnen, dass es hier nicht möglich gewesen wäre, das Ziel der Optimierung allein nur durch das Berücksichtigen von Kohärenztransferwegen zu erreichen. Vielmehr beruht die COOP-Lösung auf der simultane Optimierung von spezifischen Pulsformen (Sättigungspulse) kombiniert mit dem resultierenden einfachen Phasenzyklus. Wie hier gezeigt wurde, unterscheiden sich COOP-Pulse im Allgemeinen nicht einfach durch die Gesamtphase.

In den vorgestellten COOP Beispielen wurde eine konstante Empfängerphase angenommen. Es ist jedoch einfach diese Einschränkung durch Hinzufügen einer zusätzlichen Kontrolle für die Empfängerphase aufzuheben um eine erhöhte Flexibilität wie in konventionellen Phasenzykeln oder in der Differenzspektrokopie zu erhalten.

In der konventionellen Differenzspektroskopie (Ernst, Bodenhausen, Wokaun, Principles of nuclear magnetic resonance spectroscopy. Clarendon Press, 1987) werden oft verschiedene Pulse in aufeinanderfolgenden Sans angewandt. Diese Pulse sind aber typischerweise entweder einfache Rechteckpulse oder sind für einen einzelnen Scan optimiert, ohne dass sie die volle Flexibilität des hier offenbarten COOP-Verfahrens ausnutzen könnten. Dies wurde beispielhaft für das Problem der Lösemittelunterdrückung ("COOP-WET") gezeigt. Durch die Möglichkeit der gegenseitigen Kompensation von Puls-Imperfektionen ergeben sich neue Freiheitsgrade für die Optimierung, die insgesamt zu besseren gemittelten Eigenschaften führen.

Das erfindungsgemäße Verfahren ist nicht dadurch beschränkt, dass pro Scan nur ein Puls ersetzt wird. Obwohl wir als Beispiele nur Fälle gezeigt haben, in denen nur ein Puls variiert wird, können analog wie beim Phasenzykeln mehrere COOP-Zyklen gleichzeitig auf unterschiedliche Pulse in der Sequenz angewendet werden. Gleichermaßen ist es möglich bei Ausführungsformen, die mehrere COOP-Pulse für einen einzelnen Scan optimieren, wie zum Beispiel das COOP-INEPT-Verfahren, die Optimierung auf mehrere Scans auszudehnen. Durch die somit zugelassenen weiteren Freiheitsgrade können noch robustere Pulse erzeugt werden.

Im Gegensatz zu Phasenzykeln, ist man bei den Ausführungsformen der Erfindung nicht auf einen globalen Phasenschub der Pulse beschränkt, sondern sowohl die Amplituden- als auch und Phasen-Modulation der Pulse wird simultan optimiert (dies beinhaltet auch eine mögliche Frequenzmodulation der Pulse, da diese immer auch als Phasenmodulation ausgedrückt werden kann). Es ist bei allen Ausführungsformen der Erfindung möglich, selektiv nur die Amplituden- oder Phasenmodulation zu optimieren.

Das hier vorgestellte Gradienten-basierte Verfahren demonstriert, dass die effiziente simultane Optimierung auch von komplizierten COOP-Pulsen möglich ist. Die Erfindung ist jedoch nicht auf dieses spezielle Optimierungsverfahren beschränkt, d. h. es erstreckt sich auch auf simultan optimierte Pulse mit gewünschten gemittelten bzw. kooperativen Eigenschaften, die durch andere Verfahren gefunden werden. So beschreiben Levante, Bremi und Ernst in J. Magn. Reson. A 121 (1966) 167-177 ein alternatives Verfahren zur Berechnung von Gradienten.

Bei den Ausführungsformen der Erfindung, bei denen die Beiträge aller Scans gemittelt werden, können, statt einer Gleichgewichtung, die Beiträge der Scans beliebig gewichtet werden. Von Interesse ist dies insbesondere bei Anwendungen, in denen keine Dummy-Scans erwünscht sind und daher zu Beginn des ersten Scans noch die volle Gleichgewichtsmagnetisierung zur Verfügung steht, während zu Beginn der weiteren Scans die Gleichgewichtsmagnetisierung noch nicht wieder voll erreicht wurde. Eine andere Anwendung, ber der dies relevant sein könnte sind Experimente mit Hyperpolarisation.

In einer weiteren Ausführungsform der Erfindung werden Signale der verschiedenen Scans, für die COOP-Pulse optimiert wurden, separat abgespeichert und auf beliebige Weise (z. B. unterschiedliche Gewichtung) miteinander kombiniert, beispielsweise um leicht unterschiedliche Anfangsmagnetisierungen auszugleichen.

In einer weiteren Ausführungsform der Erfindung werden COOP-Pulse optimiert, deren individuelle Scans unterschiedlich miteinander kombiniert werden, um unterschiedliche Resultate zu erhalten. So werden in einer besonders bevorzugten Ausführungsform der Erfindung COOP-Pulse optimiert, deren individuelle FIDs beispielsweise durch Addition bzw. Subtraktion jeweils ein anderes gewünschtes Resultat liefern.

In einer weiteren Ausführungsform der Erfindung werden COOP-Pulse optimiert, so dass durch Durchlaufen eines COOP-Pulszyklus und Aufsummieren der resultierenden FIDs ein Isotopenfilter erhalten wird, der selektiv nur Signale von Protonen, die eine direkte Kopplung zu einem einzigen Isotop eines bestimmten Element aufweisen, unterdrückt oder passieren lässt und Signale von Protonen, die an ein anderes Isotop des gleichen Elementes gebunden sind, gegenteilig behandelt, also passieren lässt oder unterdrückt. In einem derart durchgeführten Experiment, sind dann nur Signale von Protonen zu sehen, die an das gleiche Isoptop eines Elements gebunden sind. So werden zum Beispiel Signale von $^1$H-$^{13}$C-Gruppen unterdrückt und Signale von $^1$H-$^{12}$C-Gruppen nicht, so dass selektiv $^1$H-$^{13}$C-Signale herausgefiltert werden. Mögliche Isotopenpaare für derartige Isotopenfilter sind beispielsweise $^{13}$C/$^{12}$C bzw. $^{15}$N/$^{14}$N.

In einer weiteren Ausführungsform der Erfindung werden COOP-Pulse optimiert, so dass durch Durchlaufen eines COOP-Pulszyklus und Aufsummieren der resultierenden FIDs ein verbesserter Multiplizitätsfilter erhalten wird, so wie er bereits durch die DEPT-Sequenz von Pegg und Bendall (J. Magn. Reson. 55 (1983) 114-127)bekannt ist. Somit würden nur Signale bestimmter $^1$H$_n$-$^{13}$C-Gruppen für einen Wert für n sichtbar sein, wohingegen sich andere bei Aufsummieren der FIDs auslöschen.

In einer weiteren Ausführungsform der Erfindung werden COOP-Pulse optimiert, so dass durch Durchlaufen eines COOP-Pulszyklus und Aufsummieren der resultierenden FIDs ein verbesserter Multiquantenfilter erhalten wird, so dass nur Signale einer bestimmten Kohärenzordnung zugelassen werden, andere hingegen unterdrückt werden.

In einer weiteren Ausführungsform der Erfindung werden COOP-Pulse für NMR- und Imaginganwendungen optimiert, so dass durch Durchlaufen eines COOP-Pulszyklus und Aufsummieren der Systemzustände zwischen zwei Signalen maximierter Kontrast erhalten wird, beispielsweise dadurch, dass die individuellen Pulse Systemzustände mit entgegengesetztem Vorzeichen erzeugen, wobei sich die beiden betreffenden Signale durch eine beliebige Eigenschaft unterscheiden. Diese Eigenschaften können beispielsweise $T_1$- und/oder $T_2$-Relaxationszeiten, chemische Verschiebung, Ort in der Probe, Diffusions-koeffizient, usw. sein.

In einer weiteren Ausführungsform der Erfindung werden in aufeinanderfolgenden Scans unterschiedliche (aber simultan optimierte und daher "kooperierende") Entkopplungssequenzen anwendet, um z. B. eine bessere Unterdrückung von Entkopplungs-Seitenbändern zu erreichen.

In einer weiteren Ausführungsform der Erfindung werden in aufeinanderfolgenden Scans unterschiedliche (aber simultan optimierte und daher "kooperierende") Pulse angewendet, die durch zusätzliche Mittelung der resultierenden FIDs bestimmte Kohärenztransferwege selektieren, andere Ko-härenztransferwege jedoch unterdrücken um beispielsweise verbesserte Phasenzyklen zu erhalten.

In einer weiteren Ausführungsform der Erfindung werden in aufeinanderfolgenden Scans unterschiedliche (aber simultan optimierte und daher "kooperierende") Pulse angewendet, die verbesserte Anregungspulse darstellen.

In einer weiteren Ausführungsform der Erfindung werden Pulse für einen Scan optimiert, die als Multiquantenfilter eigesetzt werden können.

In einer weiteren Ausführungsform der Erfindung werden Pulse für einen Scan optimiert, die als Mischpulse, beispielsweise für heteronukleare und/oder homonukleare Hartmann-Hahn-Transfer Experimente wie beispielsweise TOC-SY, eingesetzt werden können.

In einer weiteren Ausführungsform der Erfindung werden Pulse für einen Scan optimiert, die einen Diffusionsdelay flankieren können.

In einer weiteren Ausführungsform der Erfindung werden Pulse für einen Scan optimiert, die einen Delay zur Entwicklung von chemischer Verschiebung und/oder Kopplung flankieren können.

Bevorzugte Anwendungsgebiete der Erfindung liegen im Bereich der NMR Spektroskopie, aber ebenso bei anderen spektroskopischen Anwendungen, wie z.B. Elektron-Spin-Resonanz oder optische Spektroskopie. Anwendungen in der NMR-Bildgebung mit medizinischen Anwendungen (aber auch anderen Anwendungen, z.B. in der Materialwissenschaft) sind abzusehen, z. B. durch schichtselektive Pulse ohne Artefakte in den Übergangsbereichen. Außerdem könnte COOP-Pulse in der Quanteninformationsverarbeitung Anwendungen finden, wobei diese Aufzählung nicht abschließend ist.

Weitere bevorzugte Anwendungsgebiete der vorliegenden Erfindung umfassen NMR und NQR ("nuclear quadrupole resonance") Spektroskopie in flüssiger Phase, in flüssigkristalliner Phase und in Gasphase sowie Festkörper NMR-Spektroskopie.

Weitere bevorzugte Anwendungsgebiete der vorliegenden Erfindung umfassen NMR-Spektroskopie von Biopolymeren wie RNS, DNS, Proteinen sowie NMR-Spektroskopie von Biomolekülen.

Weitere bevorzugte Anwendungsgebiete der vorliegenden Erfindung umfassen Präzisionsmessungen, wie beispielsweise Zeitmessungen (beispielsweise mit Atomuhren), Magnetfeldmessüngcn, magnetische Gyroskope und Ortsbestimmungen, wie sie beispielsweise zur Navigation erforderlich sind. Weitere bevorzugte Anwendungsgebiete der vorliegenden Erfindung umfassen Ionenfallen, Quanteninformationsverarbeitung, Quantencomputing, Quantenkommunikation, Quantenkryptographie, Quantenspeicherung ("quantum memory"), Steuerung von Quantenbits ("qubits").

Ein besonders bevorzugtes Anwendungsgebiet der vorliegenden Erfindung umfasst die quantitative NMR-Spektroskopie, wie sie beispielsweise in der Polymeranalytik und der Qualitätskontrolle von chemischen Produkten zum Einsatz kommt. "Quantitative NMR-Spektroskopie" umfasst die hochgenaue Bestimmung von Signalintegralen zur quantitativen Analyse chemischer Substanzen, ohne jedoch darauf beschränkt zu sein.

Das erfindungsgemäße Verfahren kann auch in folgenden Gebieten zum Einsatz kommen:

- Ionenfallen

- Atomfallen

- Atomstrathlexperimente

- Neutronenstrahl-Experimente

- solid-state Qubits

- Quantenpunkte (Quantum dots),

- Stickstoff-Fehlstellen in Diamant ("NV centers in diamond")

- Supraleitende Qubits (Josephson-Devices)

Auf Optimal Control basierende Techniken zur effizienten Optimierung komplexer COOP-Pulse erschließen neue Wege der Pulssequenzoptimierung. Ziel der hier vorgestellten Beispiele war es, das grundlegende Konzept und mögliche Anwendungen von COOP-Pulsen vorzustellen. Es wurde beispielhaft gezeigt, dass das erfindungsgemäße Verfahren für Wasserunterdrückungstechniken wie WET nützlich sein kann. Für die praktische Lösemittelunterdrückung ist es jedoch notwendig, die Optimierungskriterien für die COOP-Pulse anzupassen, was für den Fachmann mithilfe der vorliegenden Erfindung leicht zu realisieren wäre und somit eine weitere Ausführungsform der Erfindung darstellt. Es ist gleichermaßen wichtig zu erwähnen, dass der vorliegende Algorithmus zur Optimierung von COOP-Pulsen einfach verallgemeinert werden kann, um Relaxationseffekte zu berücksichtigen. So haben Khaneja, Reiss, Kehlet, Schulte-Herbrüggen, Glaser, Gershenzon, Kobzar, Luy und Skinner gezeigt (J. Magn. Reson. 172 (2005) 296-305; J. Magn. Reson. 188 (2007) 330-336), dass Relaxationseffekte auf einfache Weise berücksichtigt werden können. Mögliche Anwendungsgebiete der vorliegenden Erfindung und ihrer Ausführungsformen umfassen Kernmagnetische-Resonanz-(NMR)-Spektroskopic, Elektronenspin-Resonanz-(ESR)-Spektroskopie, Magnetresonanz-(MR) -Imaging, optische Spektroskopie, Mikrowellenspektroskopie, Quanteninformationsverarbeitung, wobei dies keine abschließende Aufzählung ist.

Die Erfindung betrifft zum Einen ein gradientenbasiertes oder numerisches Optimierungsverfahren zur simultanen Optimierung einer beliebigen Anzahl $N \geq 2$ von elektromagnetischen Pulsen, gekennzeichnet durch folgende Schritte:

zuerst durch eine Mittelung der individuellen Systemzustände, welche durch die elektromagnetischen Pulse erzeugt werden und mit einem Formalismus zur Beschreibung von Spinsystemen, umfassend die Bloch-Gleichungen, den Dichteoperatorformalismus, den Produktoperatorformalismus, sowie die Modifikationen dieser Formalismen zur Berücksichtigung von Relaxation beziehungweise Radiation Damping, beschrieben werden, um die unerwünschten Einzelbeiträge der Systemzustände zu eliminieren und erwünschte Einzelbeiträge der Systemzustände zu erhalten und einen möglichen zweiten Schritt, in dem die durch die Pulse erzeugten individuellen Systemzustände nicht den physikalischen Endzuständen des Systems entsprechen müssen und nach der im ersten Schritt beschriebenen Optimierung einer oder mehrere der optimierten Pulse durch weitere Operationen, umfassend Zeit- und/oder Phaseninversion und/oder Gesamtphasenverschiebung modifiziert werden.

Zum Anderen betrifft die Erfindung ein gradientenbasiertes oder numerisches Verfahren zur simultanen Optimierung einer beliebigen Anzahl $N \geq 2$ von elektromagnetischen Pulsen, gekennzeichnet durch folgende Schritte:

zuerst dadurch, dass individuellen Systemzustände, welche durch die elektromagnetischen Pulse erzeugt werden und mit einem Formalismus zur Beschreibung von Spinsystemen, umfassend die Bloch-Gleichungen, den Dichteoperatorformalismus, den Produktoperatorformalismus, sowie die Modifikationen dieser Formalismen zur Berücksichtigung von Relaxation beziehungweise Radiation Damping, beschrieben werden, symmetrisch zu einer Achse in der transversalen Ebene sind, deren Phase konstant ist oder linear vom Offset abhängt oder die Einzelbeiträge der Systemzustände entgegengesetzte Vorzeichen aufweisen (maximaler Kontrast)
und einen möglichen zweiten Schritt, in dem die durch die Pulse erzeugten individuellen Systemzustände nicht den physikalischen Endzuständen des Systems entsprechen müssen und nach der im ersten Schritt beschriebenen Optimierung einer oder mehrere der optimierten Pulse durch weitere Operationen, umfassend Zeit- und/oder Phaseninversion und/oder Gesamtphasenverschiebung modifiziert werden.

## Patentansprüche

1. Verfahren zur simultanen Optimierung einer Gruppe von N elektromagnetischen Pulsen $P^{(j)}$, mit N>1, wobei die Pulse zur Beeinflussung von Systemzuständen eines Spinsystems dienen,
wobei ein auf Optimal Control basierender Algorithmus verwendet wird, mit folgenden Schritten:

   a. Auswahl von N elektromagnetischen Anfangspulsen $P^{(j)}$ mit Dauer $T^{(j)}$, mit Kontrollen $v_x^{(j)}(t)$ und $v_y^{(j)}(t)$ und $j \in \{1; 2; ... ;N\}$, wobei die Kontrollen $v_x^{(j)}(t)$ und $v_y^{(j)}(t)$ die x- und y- Komponenten der RF-Amplituden der Anfangspulse $P^{(j)}$ beschreiben,
   b. Berechnung von N Trajektorien der Systemzustände des Spinsystems unter Einwirkung der Pulse $P^{(j)}$ durch Verwenden von quantenmechanischen Bewegungsgleichungen, wobei jeweils ein gegebener Anfangszustand angenommen wird,
   c. Definition eines Qualitätsfaktors $\Phi$ der zumindest von den Systemendzuständen zum Zeitpunkt $T^{(j)}$ abhängt und berücksichtigt, dass unerwünschte Einzelbeiträge der Systemzustände eliminiert und erwünschte Einzelbeiträge der Systemzustände erhalten werden sollen,
   d. Berechnung von Costates $\lambda^{(j)}(\tau^{(j)})$,
   e. Berechnung von N Trajektorien der Costates $\lambda^{(j)}(t)$ für $0 \leq t \leq T^{(j)}$,
   f. Berechnung der Gradienten des Qualitätsfaktors $\Phi$, bezüglich der Kontrollen $v_x^{(j)}(t)$ und $v_y^{(j)}(t)$ für beliebig viele Zeitpunkte t,
   g. Addition der mit einer Schrittweite skalierten Gradienten zu den Kontrollen $v_x^{(j)}(t)$ und $v_y^{(j)}(t)$, wodurch aktualisierte Kontrollen $v_x^{(j)}(t)$ und $v_y^{(j)}(t)$ erhalten werden,
   h. Wiederholung der Schritte b - g unter Verwendung der aktualisierten Kontrollen $v_x^{(j)}(t)$ und $v_y^{(j)}(t)$ bis ein definiertes Abbruchkriterium erfüllt ist.

2. Optimierungsverfahren nach Anspruch 1,
**dadurch gekennzeichnet,**
**dass** in Schritt f die Gradienten des Qualitätsfaktors $\Phi$ zu jedem Zeitpunkt t berechnet werden.

3. Optimierungsverfahren nach Anspruch 1 oder 2,
**dadurch gekennzeichnet,**
**dass** die Systemzustände des Spinsystems durch die Magnetisierungsvektoren $M^{(j)}(t)$ beschreiben werden, so dass in Schritt b die Trajektorien der Magnetisierungsvektoren $M^{(j)}(t)$ durch Verwenden der Bloch-Gleichungen für $0 \leq t \leq T$, berechnet werden,
der Qualitätsfaktor $\Phi$ von den Endmagnetisierungsvektoren $M^{(j)}(\tau^{(j)})$ abhängt,
in Schritt e die Berechnung der Trajektorien der Costate-Vektoren $\lambda^{(j)}(t)$ für $0 \leq t \leq T$ unter Verwendung der Bewegungsgleichungen für die Costate-Vektoren erfolgt gemäß

$$\dot{\lambda}(t) = 2\pi \nu_e(t) \times \lambda(t),$$

$$\frac{\delta \Phi}{\delta_{\nu_y^{(j)}(t)}} = M_z^{(j)}(t)\lambda_x^{(j)}(t) - M_x^{(j)}(t)\lambda_z^{(j)}(t)$$

und in Schritt f die Berechnung der Gradienten des Qualitätsfaktors $\Phi$ durch Berechnung der x- und y-Komponenten des Vektorproduktes $M^{(j)}(t) \times \lambda^{(j)}(t)$ erfolgt:

$$\frac{\delta \Phi}{\delta_{\nu_x^{(j)}(t)}} = M_y^{(j)}(t)\lambda_z^{(j)}(t) - M_z^{(j)}(t)\lambda_y^{(j)}(t),$$

$$\frac{\delta \Phi}{\delta_{\nu_y^{(j)}(t)}} = M_z^{(j)}(t)\lambda_x^{(j)}(t) - M_x^{(j)}(t)\lambda_z^{(j)}(t)$$

4.  Verfahren nach Anspruch 1 oder 2,
    **dadurch gekennzeichnet,**
    **dass** die Systemzustände mit Hilfe des Dichteoperatorformalismus oder des Produktoperatorformalismus beschrieben oder Modifikationen dieser Formalismen zur Berücksichtigung von Relaxation oder Radiation Damping beschrieben werden.

5.  Optimierungsverfahren nach einem der Ansprüche 1 bis 3,
    **dadurch gekennzeichnet,**
    **dass** die in Schritt f berechneten Gradienteninformation in Algorithmen, die das Verfahren des steilsten Anstiegs verwenden, eingesetzt werden.

6.  Optimierungsverfahren nach Anspruch 1 bis 4,
    **dadurch gekennzeichnet,**
    **dass** die in Schritt f berechneten Gradienten durch Anwendung eines konjugierten-Gradienten-Verfahrens oder eines quasi-Newton-Verfahrens skaliert werden und diese skalierten Gradienten in Schritt g zu den Kontrollen $v_x^{(j)}(t)$ und $v_y^{(j)}(t)$ addiert werden.

7.  Optimierungsverfahren nach einem der Ansprüche 1 bis 6,
    **dadurch gekennzeichnet,**
    **dass** die Pulse in aufeinander folgenden Scans an einer einzigen Stelle der Pulssequenz zur Anwendung kommen sollen, und
    **dass** der Qualitätsfaktor $\Phi$ vom Mittelwert der Systemendzuständen abhängt.

8.  Optimierungsverfahren nach Anspruch 7,
    **dadurch gekennzeichnet,**
    **dass** die Beiträge der Scans zum Mittelwert der Systemendzustände gewichtet werden.

9.  Optimierungsverfahren nach einem der Ansprüche 1 bis 6,
    **dadurch gekennzeichnet,**
    **dass** die Pulse in einem einzigen Scan an unterschiedlichen Stellen einer Pulssequenz zur Anwendung kommen sollen, und
    **dass** die Systemendzustände symmetrisch zu einer Achse in der transversalen Ebene sind, wobei die Systemendzustände durch eine Spieglung an der Symmetrieachse ineinander übergeführt werden können.

**10.** Optimierungsverfahren nach Anspruch 9,
**dadurch gekennzeichnet,**
**dass** die Symmetrieachse in der transversalen Ebene eine einheitliche Phase oder eine Phase, die linear vom Offset abhängt, aufweist.

**11.** Optimierungsverfahren nach Anspruch 9 oder 10,
**dadurch gekennzeichnet,**
**dass** es sich bei den Pulsen $P^{(j)}$ um Pulse handelt, die transversale Magnetisierung erzeugen.

**12.** Optimierungsverfahren nach einem der vorhergehenden Ansprüche,
**dadurch gekennzeichnet,**
**dass** der Qualitätsfaktor $\Phi$ ausschließlich von den Systemendzuständen abhängt.

**13.** Verwendung des Optimierungsverfahrens nach einem der vorhergehenden Ansprüche, im Bereich der NMR-Spektroskopie, MRI, Elektron-Spin-Resonanz-Spektroskopie und in der optischen Spektroskopie.

**Claims**

**1.** Method for the simultaneous optimization of a group of N electromagnetic pulses $P^{(j)}$ with N>1, wherein the pulses are used for the manipulation of system states of the spin system,
wherein an optimal control based algorithm is used, comprising the steps:

    a. choosing N electromagnetic initial pulses $P^{(j)}$ having a duration $T^{(j)}$, having controls $v_x^{(j)}(t)$ and $v_y^{(j)}(t)$ and $j \in \{1;2;...;N\}$, wherein the controls $v_x^{(j)}(t)$ and $v_y^{(j)}(t)$ describe the x and y components of the RF amplitudes of the initial pulses $P^{(j)}$,
    b. calculating N trajectories of the system states of the spin system experiencing the pulses $P^{(j)}$ by using quantum mechanical equations of motion, wherein a given initial state is assumed, respectively,
    c. defining a quality factor $\Phi$ that is at least dependent on the final system states at the point in time $T^{(j)}$ and that takes into account that undesired single contributions of the system states are to be eliminated and desired single contributions of the system states are to be obtained,
    d. calculating costates $\lambda^{(j)}(\tau^{(j)})$,
    e. calculating N trajectories of the costates $\lambda^{(j)}(t)$ for $0 \leq t \leq \tau^{(j)}$,
    f. calculating the gradients of the quality factor $\Phi$ with respect to the controls $v_x^{(j)}(t)$ and $v_y^{(j)}(t)$ for an arbitrary number of points in time t,
    g. adding the gradients scaled by an increment to the controls $v_x^{(j)}(t)$ and $v_y^{(j)}(t)$, whereby updated controls $v_x^{(j)}(t)$ and $v_y^{(j)}(t)$ are obtained,
    h. repeating the steps b - g while using the updated controls $v_x^{(j)}(t)$ and $v_y^{(j)}(t)$ until a defined abortion criterion is fulfilled.

**2.** Optimization method according to claim 1, **characterized in that** in step f, the gradients of the quality factor $\Phi$ are calculated for each point in time t.

**3.** Optimization method according to claim 1 or 2, **characterized in that** the system states of the spin system are described by the magnetization vectors $\mathbf{M}^{(j)}(t)$ so that in step b, the trajectories of the magnetization vectors $\mathbf{M}^{(j)}(t)$ are calculated for $0 \leq t \leq \tau$ using the Bloch equations,
the quality factor $\Phi$ depends on the final magnetization vectors $\mathbf{M}^{(j)}(\tau^{(j)})$, in step e, the calculation of the trajectories of the costate vectors $\lambda^{(j)}(t)$ for $0 \leq t \leq \tau$ is carried out using the equations of motion for the costate vectors according to

$$\dot{\lambda}(t) = 2\pi\nu_e(t) \times \lambda(t),$$

$$\frac{\delta\Phi}{\delta\nu_y^{(j)}(t)} = M_z^{(j)}(t)\lambda_x^{(j)}(t) - M_x^{(j)}(t)\lambda_z^{(j)}(t)$$

and in step f, the calculation of the gradients of the quality factor $\Phi$ is carried out by calculating the x and y components of the vector product $\mathbf{M}^{(j)}(t) \times \lambda^{(j)}(t)$:

$$\frac{\delta\Phi}{\delta\nu_x^{(j)}(t)} = M_y^{(j)}(t)\lambda_z^{(j)}(t) - M_z^{(j)}(t)\lambda_y^{(j)}(t)$$

$$\frac{\delta\Phi}{\delta\nu_y^{(j)}(t)} = M_z^{(j)}(t)\lambda_x^{(j)}(t) - M_x^{(j)}(t)\lambda_z^{(j)}(t)$$

4. Method according to claim 1 or 2, **characterized in that** the system states are described by using the density operator formalism or the product operator formalism or by modifications of these formalisms for taking relaxation or radiation damping into account.

5. Optimization method according to any one of the claims 1 to 3, **characterized in that** the gradient information calculated in step f is used in algorithms using the method of steepest ascent.

6. Optimization method according to any one of the claims 1 to 4, **characterized in that** the gradients calculated in step f are scaled by applying a conjugated-gradient method or a quasi-Newton method, and these scaled gradients are added to the controls $v_x^{(j)}(t)$ and $v_y^{(j)}(t)$ in step g.

7. Optimization method according to any one of the claims 1 to 6, **characterized in that** the pulses in subsequent scans are to be applied at a single position of the pulse sequence and the quality factor $\Phi$ depends on the average value of the final system states.

8. Optimization method according to claim 7, **characterized in that** the contributions of the scans to the average value of the final system states are weighted.

9. Optimization method according to any one of the claims 1 to 6, **characterized in that** the pulses are to be applied in a single scan at different positions of a pulse sequence and the final system states are symmetrical with respect to an axis in the transverse plane, wherein the final system states can be converted into one another by reflection on the symmetry axis.

10. Optimization method according to claim 9, **characterized in that** the symmetry axis in the transverse plane has a uniform phase or a phase that linearly depends on the offset.

11. Optimization method according to claim 9 or 10, **characterized in that** the pulses $P^{(j)}$ are pulses creating transverse magnetization.

12. Optimization method according to any one of the preceding claims, **characterized in that** the quality factor $\Phi$ exclusively depends on the final system states.

13. Use of the optimization method according to any one of the preceding claims in the field of NMR spectroscopy, MRI, electron spin resonance spectroscopy and in optical spectroscopy.

**Revendications**

1. Procédé d'optimisation simultanée d'un groupe de N impulsions électromagnétiques P$^{(j)}$, avec N > 1, lesquelles impulsions servent à influencer des états de système d'un système de spins,
dans lequel on utilise un algorithme basé sur le contrôle optimal, présentant les étapes suivantes :

   a. sélection de N impulsions électromagnétiques initiales P$^{(j)}$ de durée T$^{(j)}$, avec des contrôles $v_x^{(j)}(t)$ et $v_y^{(j)}(t)$ et j € {1 ; 2 ; ... ; N}, les contrôles $v_x^{(j)}(t)$ et $v_y^{(j)}(t)$ décrivant les composantes x et y des amplitudes RF des impulsions initiales P$^{(j)}$,
   b. calcul de N trajectoires des états de système du système de spins sous l'influence des impulsions P$^{(j)}$ par utilisation d'équations de mouvement de la mécanique quantique, un état initial donné étant supposé à chaque fois,
   c. définition d'un facteur de qualité Φ qui dépend au moins des états de système finaux à l'instant T$^{(j)}$ et tient compte du fait que les contributions individuelles non désirées des états de système doivent être éliminées et les contributions individuelles désirées des états de système être conservées,
   d. calcul d'états adjoints λ$^{(j)}$(T$^{(j)}$),
   e. calcul de N trajectoires des états adjoints λ$^{(j)}$(t) pour 0 ≤ t ≤ T$^{(j)}$,
   f. calcul des gradients du facteur de qualité Φ, concernant les contrôles $v_x^{(j)}(t)$ et $v_y^{(j)}(t)$ pour un nombre quelconque d'instants t,
   g. addition des gradients mis à l'échelle avec un pas de progression aux contrôles $v_x^{(j)}(t)$ et $v_y^{(j)}(t)$, de manière à obtenir des contrôles $v_x^{(j)}(t)$ et $v_y^{(j)}(t)$ actualisés,
   h. répétition des étapes b à g en utilisant les contrôles $v_x^{(j)}(t)$ et $v_y^{(j)}(t)$ actualisés jusqu'à ce qu'un critère d'arrêt défini soit rempli.

2. Procédé d'optimisation selon la revendication 1,
**caractérisé en ce**
**qu'**à l'étape f, les gradients du facteur de qualité Φ sont calculés à chaque instant t.

3. Procédé d'optimisation selon la revendication 1 ou 2,
**caractérisé en ce**
**que** les états de système du système de spins sont décrits par les vecteurs de magnétisation M$^{(j)}$(t), de sorte que à l'étape b, les trajectoires des vecteurs de magnétisation M$^{(j)}$(t) sont calculés en utilisant les équations de Bloch pour 0 ≤ t ≤ T,
le facteur de qualité Φ dépend des vecteurs de magnétisation finaux M$^{(j)}$(T$^{(j)}$), à l'étape e, le calcul des trajectoires des vecteurs d'état adjoint λ$^{(j)}$(t) pour 0 ≤ t ≤ T est effectué en utilisant les équations de mouvement pour les vecteurs d'état adjoint selon

$$\lambda(t) = 2\pi v_e(t) \ x \ \lambda(t),$$

$$\frac{\delta\Phi}{\delta_{v_y^{(j)}(t)}} = M_z^{(j)}(t)\lambda_x^{(j)}(t) - M_x^{(j)}(t)\lambda_z^{(j)}(t)$$

et à l'étape f, le calcul des gradients du facteur de qualité Φ est effectué par calcul des composantes x et y du produit de vecteurs M$^{(j)}$(t) x λ$^{(j)}$(t) :

$$\frac{\delta\Phi}{\delta_{v_x^{(j)}(t)}} = M_y^{(j)}(t)\lambda_z^{(j)}(t) - M_z^{(j)}(t)\lambda_y^{(j)}(t),$$

$$\frac{\delta \Phi}{\delta_{v_y^{(j)}(t)}} = M_z^{(j)}(t)\lambda_x^{(j)}(t) - M_x^{(j)}(t)\lambda_z^{(j)}(t)\,.$$

**4.** Procédé selon la revendication 1 ou 2,
**caractérisé en ce**
**que** les états de système sont décrits à l'aide du formalisme de l'opérateur densité ou du formalisme de l'opérateur produit ou de modifications de ces formalismes pour tenir compte de la relaxation ou de l'amortissement de radiation.

**5.** Procédé d'optimisation selon l'une des revendications 1 à 3,
**caractérisé en ce**
**que** les informations de gradient calculées à l'étape f sont utilisées dans des algorithmes qui utilisent le procédé de la plus forte pente.

**6.** Procédé d'optimisation selon les revendications 1 à 4,
**caractérisé en ce**
**que** les gradients calculés à l'étape f sont mis à l'échelle en utilisant la méthode du gradient conjugué ou la méthode de quasi-Newton et ces gradients mis à l'échelle sont additionnés à l'étape g aux contrôles $v_x^{(j)}(t)$ et $v_y^{(j)}(t)$.

**7.** Procédé d'optimisation selon l'une des revendications 1 à 6,
**caractérisé en ce**
**que** les impulsions doivent être utilisées en balayages successifs à un seul endroit de la séquence d'impulsions, et
**que** le facteur de qualité Φ dépend de la valeur moyenne des états de système finaux.

**8.** Procédé d'optimisation selon la revendication 7,
**caractérisé en ce**
**que** les contributions des balayages à la valeur moyenne des états de système finaux sont pondérées.

**9.** Procédé d'optimisation selon l'une des revendications 1 à 6,
**caractérisé en ce**
**que** les impulsions doivent être utilisées en un seul balayage à différents endroits d'une séquence d'impulsions, et
**que** les états de système finaux sont symétriques par rapport à un axe dans le plan transversal, les états de système finaux pouvant être transformés l'un dans l'autre par réflexion par rapport à l'axe de symétrie.

**10.** Procédé d'optimisation selon la revendication 9,
**caractérisé en ce**
**que** l'axe de symétrie dans le plan transversal présente une phase uniforme ou une phase qui dépend linéairement de l'offset.

**11.** Procédé d'optimisation selon la revendication 9 ou 10,
**caractérisé en ce**
**que** les impulsions $P^{(j)}$ sont des impulsions qui produisent une magnétisation transversale.

**12.** Procédé d'optimisation selon l'une des revendications précédentes, **caractérisé en ce**
**que** le facteur de qualité Φ dépend exclusivement des états de système finaux.

**13.** Utilisation du procédé d'optimisation selon l'une des revendications précédentes, dans le domaine de la spectroscopie RMN, de l'IRM, de la spectroscopie par résonance de spin électronique et dans la spectroscopie optique.

Fig. 1:

Fig. 2:

Fig. 3:

Fig. 4:

Fig. 5:

A single pulse
B two COOP pulses
C three COOP pulses

Fig. 6:

Fig. 7:

experiment

simulation

$\nu_{off}$ [kHz]

$\nu_{off}$ [kHz]

$\overline{M}_x$

$\phi$ [deg]

Fig. 8:

Fig. 9:

Fig. 10:

A $\quad 90^\circ_x 90^\circ_y 90^\circ_{-x} 90^\circ_{-y}$

B $\quad 90^\circ_x; 90^\circ_x; 90^\circ_x; 270^\circ_{-x}$

C $\quad$ single optimized pulse

D $\quad$ COOP (N = 2)

Fig. 11:

Fig. 12:

## COOP INEPT

1/(4J)

1/(8J)    1/(8J)

## ICEBERG COOP INEPT

T'                                T'

1/(8J) - T'      1/(8J) - T'

Fig. 13:

**IN DER BESCHREIBUNG AUFGEFÜHRTE DOKUMENTE**

**In der Beschreibung aufgeführte Patentdokumente**

- US 688348 A

**In der Beschreibung aufgeführte Nicht-Patentliteratur**

- **LEVITT.** *Prog. Nucl. Magn. Reson. Spectrosc.,* 1986, vol. 18, 61-122
- Encyclopedia of Nuclear Magnetic Resonance. Wiley, 1996
- **WARREN ; SILVER.** *Adv. Magn. Reson.,* 1988, vol. 12, 247-384
- **KOBZAR et al.** *J. Magn. Reson.,* 2004, vol. 170, 236-243
- *J. Magn. Reson.,* 2008, vol. 194, 58-66
- **NEVES et al.** *J. Magn. Reson.,* 2006, vol. 181, 126-134
- **BRYSON ; HO.** *Applied Optimal Control,* 1975
- **KEELER.** Understanding NMR Spectroscopy. Wiley, 2005
- **BODENHAUSEN et al.** *J. Magn. Reson.,* 1984, vol. 58, 370-388
- **BAIN.** *J. Magn. Reson.,* 1984, vol. 56, 418-427
- **LEVITT et al.** *J. Magn. Reson.,* 2002, vol. 155, 300-306
- **KHANEJA et al.** *J. Magn. Reson.,* 2005, vol. 172, 296-305
- *J. Magn. Reson.,* 2003, vol. 163, 8-15
- **BRYSON et al.** *Applied Optimal Control,* 1975
- **KHANEJAET.** *J. Magn. Reson.,* 2005, vol. 172, 296-305
- **SKINNER et al.** *J. Magn. Reson.,* 2003, vol. 163, 8-1
- **SKINNER et al.** *J. Magn. Reson.,* 2003, vol. 163, 8-15
- *J. Magn. Reson.,* 2004, vol. 167, 68-74
- *J. Magn. Reson.,* 2005, vol. 172, 17-23
- **ROURKE.** *Conc. Magn. Reson.,* 2002, vol. 14, 112-129
- **GERSHENZON et al.** *J. Magn. Reson.,* 2007, vol. 188, 330-336
- **SKINNER et al.** *J. Magn. Reson.,* 2005, vol. 172, 17-23
- **FOUQUIERES et al.** Second Order Gradient Ascent Pulse Engineering. *J. Magn. Reson.*
- **SKINNER et al.** *J. Magn. Reson.,* 2004, vol. 167, 68-74

- *Prog. Nucl. Magn. Reson. Spectrosc.,* 1986, vol. 18, 61-122
- *J. Magn. Reson.,* 2008, vol. 192, 335-343
- **OGG et al.** *J. Magn. Reson. B,* 1994, vol. 104, 1-10
- **ZHANG et al.** *J. Magn. Reson.,* 2000, vol. 143, 382-386
- **BAX.** *J. Magn. Reson.,* 1985, vol. 64, 142-145
- *J. Magn. Reson.,* 2000, vol. 143, 382-386
- **KOBZAR et al.** *J. Magn. Reson.,* 2005, vol. 173, 229-235
- *J. Magn. Reson.,* 1985, vol. 64, 142-145
- Principles of nuclear magnetic resonance spectroscopy in one and two dimensions. Clarendon Press, 1987
- **EGGENBERGER et al.** *J. Magn. Reson,* 1992, vol. 100, 604-610
- **ZUIDERWEG et al.** *J. Magn. Reson.,* 1991, vol. 93, 653-658
- **RIEK.** *J. Am. Chem. Soc.,* 2003, vol. 125, 16104-16113
- **KUPCC et al.** *J. Magn. Reson.,* 2001, vol. 151, 142-145
- **KUPCE et al.** *J. Magn. Rcson.,* 2001, vol. 151, 142-145
- **KUPCE et al.** *J. Magn. Reson.,* 1996, vol. 122, 81-84
- **ZHOU et al.** *J. Magn. Reson.,* 2007, vol. 187, 225-233
- **NEVES et al.** *J. Magn. Rcson.,* 2009, vol. 201, 7-17
- **AKOKA et al.** *J. Magn. Reson.,* 2007, vol. 185, 50-58
- **NEVES et al.** *J. Magn. Reson,* 2009, vol. 201, 7-17
- **MORRIS ; FREEMAN.** *J. Am. Chem. Soc.,* 1979, vol. 101, 760-762
- *Prog. NMR Spectrosc.,* 1983, vol. 16, 163-192
- **HWANG et al.** *J. Magn. Reson. A,* 1995, 112

- **ADAMS.** *Magn. Reson. Chem.,* 2008, vol. 46, 377-380
- *J. Magn. Reson.,* 2005, vol. 176, 179-186
- **GERSHCNZON et al.** *J. Magn. Reson.,* 2008, vol. 192, 335-343
- Principles of nuclear magnetic resonance spectroscopy. Clarendon Press, 1987
- **NEVES et al.** Heteronuclear Decoupling by Optimal Tracking. *J. Magn. Reson.,* 2009, vol. 201, 7-17
- **KROTOV et al.** *Eng. Cybern.,* 1983, vol. 21, 123
- *Izv. Akad. Nauk. SSSR Tekh. Kibern.,* 1983, vol. 52, 162167
- **KONNOV et al.** *Autom. Remote Control,* 1999, vol. 60, 1427
- **PALAO et al.** *Phys. Rev. Lett.,* 2002, vol. 89, 188301
- **PALAO et al.** *Phys. Rev. A,* 2003, vol. 68, 062308
- **MADAY et al.** New formulation of monotonically convergent quantum control algorithm. *J. Chem. Phys.,* 2003, vol. 118, 81918196
- **ZHU et al.** A rapid monotonically convcrgent algorithm for quantum optimal control over the expectation value of a denite operator. *J. Chem. Phys.,* 1998, vol. 109, 385391
- **MACHNES et al.** Comparing, Optimising and Benchmarking Quantum Control Algorithms in a Unifying Programming Framework. *Phys. Rev. A,* 2011
- **EITAN et al.** Optimal control with accclerated convergence: Combining the Krotov and quasi-Newton methods. *Phys. Rev. A,* 2011, vol. 83, 053426
- Time Dependent Quantum Molecular Dynamics. **TANNOR et al.** Control of photochemical branching: Novel procedures for finding optimal pulses and global upper bounds. Plenum, 1992, 347-360
- **KEELER ; BODENHAUSEN ; KOGLER ; ERNST ; BAIN ; LEVITT ; MADHU ; HUGHES.** Understanding NMR Spectroscopy. Wiley, 2005
- *J. Magn. Reson.,* 1984, vol. 58, 370-388
- *J. Magn. Reson.,* 1984, vol. 56, 418-427
- *J. Magn. Reson.,* 2002, vol. 155, 300-306
- **ERNST ; BODENHAUSEN ; WOKAUN.** Principles of nuclear magnetic resonance spectroscopy. Clarendon Press, 1987
- **LEVANTE ; BREMI ; ERNST.** *J. Magn. Reson. A,* 1966, vol. 121, 167-177
- **PEGG ; BENDALL.** *J. Magn. Reson.,* 1983, vol. 55, 114-127
- **KHANEJA ; REISS ; KEHLET ; SCHULTE-HERBRÜGGEN ; GLASER ; GERSHENZON ; KOBZAR ; LUY ; SKINNER.** *J. Magn. Reson.,* 2005, vol. 172, 296-305
- *J. Magn. Reson.,* 2007, vol. 188, 330-336